(19) Europäisches Patentamt
European Patent Office
Office européen des brevets

(11) EP 1 235 863 B1

# (12) EUROPEAN PATENT SPECIFICATION

(45) Date of publication and mention of the grant of the patent:
**26.01.2005 Bulletin 2005/04**

(21) Application number: **00983214.8**

(22) Date of filing: **04.12.2000**

(51) Int Cl.[7]: **C08F 2/40**, C08F 4/00, C08K 5/15, C08F 290/00, C08L 33/00, C08L 51/00, G03F 7/00, C08F 2/38, C08F 2/50

(86) International application number:
**PCT/EP2000/012165**

(87) International publication number:
**WO 2001/042313 (14.06.2001 Gazette 2001/24)**

## (54) USE OF AN ADDITIVE COMPOSITION FOR INCREASING THE STORAGE STABILITY OF ETHYLENICALLY UNSATURATED RESINS

VERWENDUNG VON EINER ZUSATZZUSAMMENSETZUNG ZUR ERHÖHUNG DER LAGERSTABILITÄT VON ÄTHYLENISCHEN UNGESÄTTIGTEN HARZEN

USAGE D'UNE COMPOSITION ADDITIVE SERVANT A AUGMENTER LA STABILITE A LA CONSERVATION DE RESINES ETHYLENIQUEMENT INSATUREES

(84) Designated Contracting States:
**AT BE CH CY DE DK ES FI FR GB GR IE IT LI LU MC NL PT SE TR**

(30) Priority: **09.12.1999 CH 227099**

(43) Date of publication of application:
**04.09.2002 Bulletin 2002/36**

(73) Proprietor: **Ciba Specialty Chemicals Holding Inc.**
**4057 Basel (CH)**

(72) Inventors:
- **JUNG, Tunja**
  **79618 Rheinfelden-Herten (DE)**
- **VALET, Andreas**
  **79589 Binzen (DE)**

(56) References cited:
**EP-A- 0 828 195**
**EP-A- 0 891 989**
**WO-A-99/00450**
**WO-A-99/67298**
**DE-A- 19 728 214**
**US-A- 5 369 159**
**US-A- 5 814 692**

- **"STABILIZATION OF STYRENIC BASED COMPOUNDS IN PRESENCE OF BENZOFURANONE DERIVATIVES" RESEARCH DISCLOSURE,GB,INDUSTRIAL OPPORTUNITIES LTD. HAVANT, no. 396, 1 April 1997 (1997-04-01), pages 270-272, XP000702453 ISSN: 0374-4353**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 235 863 B1

## Description

The present invention relates to the stabilisation of ethylenically unsaturated resins against premature polymerisation or crosslinking during transportation and storage.
Unsaturated resins, especially those to be cured by radiation, frequently have to be stabilised against undesired polymerisation or crosslinking in order that they have adequate storage stability.
In the prior art, for example in US 5 863 997 or EP-A-0 306 444, there are proposed for that purpose especially phenolic compounds, more especially those based on quinone/hydroquinone or phenothiazine.
Examples of typical additives intended to prevent premature polymerisation are hydroquinone, hydroquinone derivatives, p-methoxyphenol, β-naphthol and sterically hindered phenols, e.g. 2,6-di(tert-butyl)-p-cresol.
A disadvantage of such additives is that after exposure to UV light, which is used, for example, for the radiation-curing of surface-coatings, a visible yellowing occurs. UV exposure may also occur during use, for example in the case of surface-coatings that are exposed to actinic radiation when used outdoors. In that case too the hydroquinone/quinone stabilisers used can lead to undesirable yellowing.
The problem underlying the present invention is therefore to provide stabilisers for increasing the storage stability of unsaturated polymers, oligomers and monomers that bring about adequate or even improved storage stability and give rise to no, or only slight, yellowing under the action of UV light.
It has now been found, surprisingly, that this problem is solved by adding to the polymers, oligomers or monomers compounds from the class of the benzofuran-2-ones and/or from the class of the stable sterically hindered nitroxyl free-radicals.
The compounds are known *per se* and are described for various applications in the prior art.
Examples of benzofuran-2-ones can be found in US 5 814 692 or in US 5 773 631.
Stable sterically hindered nitroxyl free-radicals are described, for example, in EP-A-581 737.
The invention relates to the use of a stable sterically hindered nitroxyl free-radical or a compound of the benzofuran-2-one type or a mixture of the two compounds for increasing the storage stability of an UV-curable composition and preventing yellowing under the action of UV-light, said composition comprising

a1) at least one oligomer, co-oligomer, polymer or copolymer or a mixture thereof having at least one ethylenically unsaturated bond; or
a2) a mixture of at least one ethylenically unsaturated monomer with at least one oligomer, co-oligomer, polymer or copolymer having at least one ethylenically unsaturated bond.

In the context of the present invention at least one ethylenically unsaturated monomer, oligomer, co-oligomer, polymer or copolymer means in each case that two, three or more of the corresponding unsaturated compounds may be present. Depending upon the field of use, in order to achieve the properties required for the application in question a complex mixture of different monomers, oligomers, co-oligomers, polymers or copolymers may be necessary.
In the case of a1), therefore, chemically different ethylenically unsaturated oligomers, co-oligomers, polymers or copolymers may be present, their ratio to one another being governed by the requirements of the field of use in question. Where there are three components, the amount of each component may be, for example, from 5 to 50 parts, the parts adding up to a total of 100.
In the case of a2), the proportion of monomers may be from 0.1 to 50 parts, preferably from 1 to 30 parts, and the oligomers, co-oligomers, polymers or copolymers together with the monomers add up to a total of 100 parts.
Preference is given to a composition in which the monomer, oligomer, co-oligomer, polymer or copolymer has at least 2 ethylenically unsaturated bonds.
The composition is preferably liquid, but where one or more components are solid solvents may also be present. Preferably as little solvent as possible is added. Where necessary, therefore, from 5 to 20% by weight, based on the total composition, is typical.
Preferably the monomers, oligomers, co-oligomers, polymers or copolymers are themselves liquid or resinous at room temperature.
In the case of solid components, these can be dissolved, for example, in a liquid component (monomer) but it is also possible to dissolve the component in a solvent beforehand and add it to the mixture in the form of a solution. Suitable solvents are, for example, ethers, esters, aliphatic or aromatic hydrocarbons, amides or alcohols.
Preference is also given to a composition wherein the monomer, oligomer, co-oligomer, polymer or copolymer contains at least one acrylate or methacrylate functionality or is a polyester derived from an unsaturated acid.
Preferably the unsaturated compounds of component (a1, a2) are photopolymerisable or radiation-curable compounds.
The ethylenically unsaturated compounds (a1, a2) may contain one or more olefinic double bonds. They may be low molecular weight (monomeric) or higher molecular weight (oligomeric). Examples of monomers having a double

bond are alkyl and hydroxyalkyl acrylates and methacrylates, e.g. methyl, ethyl, butyl, 2-ethylhexyl and 2-hydroxyethyl acrylate, isobomyl acrylate and methyl and ethyl methacrylate. Also of interest are silicone acrylates. Further examples are acrylonitrile, acrylamide, methacrylamide, N-substituted (meth)acrylamides, vinyl esters, such as vinyl acetate, vinyl ethers, such as isobutyl vinyl ether, styrene, alkyl- and halo-styrenes, N-vinylpyrrolidone, vinyl chloride and vinylidene chloride.

Examples of monomers having several double bonds are ethylene glycol diacrylate, propylene glycol diacrylate, neopentyl glycol diacrylate, hexamethylene glycol diacrylate, bis-phenol-A diacrylate, 4,4'-bis(2-acryloyloxyethoxy)diphenylpropane, trimethylolpropane triacrylate, pentaerythritol triacrylate, pentaerythritol tetraacrylate, vinyl acrylate, divinylbenzene, divinyl succinate, diallyl phthalate, triallyl phosphate, triallyl isocyanurate and tris(2-acryloylethyl) isocyanurate.

Examples of higher molecular weight (oligomeric, polymeric) polyunsaturated compounds are acrylated epoxy resins, acrylated or vinyl-ether- or epoxy-group-containing polyesters, polyurethanes and polyethers. Further examples of unsaturated oligomers are unsaturated polyester resins, which are usually produced from maleic acid, phthalic acid and one or more diols and have molecular weights of about from 500 to 3000. In addition it is also possible to use vinyl ether monomers and oligomers, and also maleate-terminated oligomers having polyester, polyurethane, polyether, polyvinyl ether and epoxide main chains. Combinations of vinyl-ether-group-carrying oligomers and polymers, as described in WO 90/01512, are especially suitable, but copolymers of vinyl ether and monomers functionalised with maleic acid also come into consideration. Such unsaturated oligomers can also be termed prepolymers.

Especially suitable are, for example, esters of ethylenically unsaturated carboxylic acids and polyols or polyepoxides, and polymers having ethylenically unsaturated groups in the chain or in side groups, e.g. unsaturated polyesters, polyamides and polyurethanes and copolymers thereof, alkyd resins, polybutadiene and butadiene copolymers, polyisoprene and isoprene copolymers, polymers and copolymers having (meth)acrylic groups in side chains, and also mixtures of one or more such polymers.

Examples of unsaturated carboxylic acids are acrylic acid, methacrylic acid, crotonic acid, itaconic acid, cinnamic acid and unsaturated fatty acids such as linolenic acid or oleic acid. Acrylic and methacrylic acid are preferred.

Suitable polyols are aromatic and especially aliphatic and cycloaliphatic polyols. Examples of aromatic polyols are hydroquinone, 4,4'-dihydroxydiphenyl, 2,2-di(4-hydroxyphenyl)propane, and novolaks and resols. Examples of polyepoxides are those based on the said polyols, especially the aromatic polyols and epichlorohydrin. Also suitable as polyols are polymers and copolymers that contain hydroxyl groups in the polymer chain or in side groups, e.g. polyvinyl alcohol and copolymers thereof or polymethacrylic acid hydroxyalkyl esters or copolymers thereof. Further suitable polyols are oligoesters having hydroxyl terminal groups.

Examples of aliphatic and cycloaliphatic polyols include alkylenediols having preferably from 2 to 12 carbon atoms, such as ethylene glycol, 1,2- or 1,3-propanediol, 1,2-, 1,3- or 1,4-butanediol, pentanediol, hexanediol, octanediol, dodecanediol, diethylene glycol, triethylene glycol, polyethylene glycols having molecular weights of preferably from 200 to 1500, 1,3-cyclopentanediol, 1,2-, 1,3- or 1,4-cyclohexanediol, 1,4-dihydroxymethylcyclohexane, glycerol, tris(β-hydroxyethyl)amine, trimethylolethane, trimethylolpropane, pentaerythritol, dipentaerythritol and sorbitol.

The polyols may be partially or fully esterified by one or by different unsaturated carboxylic acid(s), it being possible for the free hydroxyl groups in partial esters to have been modified, for example etherified, or esterified by other carboxylic acids.

Examples of esters are:

trimethylolpropane triacrylate, trimethylolethane triacrylate, trimethylolpropane trimethacrylate, trimethylolethane trimethacrylate, tetramethylene glycol dimethacrylate, triethylene glycol dimethacrylate, tetraethylene glycol diacrylate, pentaerythritol diacrylate, pentaerythritol triacrylate, pentaerythritol tetraacrylate, dipentaerythritol diacrylate, dipentaerythritol triacrylate, dipentaerythritol tetraacrylate, dipentaerythritol pentaacrylate, dipentaerythritol hexaacrylate, tripentaerythritol octaacrylate, pentaerythritol dimethacrylate, pentaerythritol trimethacrylate, dipentaerythritol dimethacrylate, dipentaerythritol tetramethacrylate, tripentaerythritol octamethacrylate, pentaerythritol diitaconate, dipentaerythritol trisitaconate, dipentaerythritol pentaitaconate, dipentaerythritol hexaitaconate, ethylene glycol diacrylate, 1,3-butanediol diacrylate, 1,3-butanediol dimethacrylate, 1,4-butanediol diitaconate, sorbitol triacrylate, sorbitol tetraacrylate, pentaerythritol-modified triacrylate, sorbitol tetramethacrylate, sorbitol pentaacrylate, sorbitol hexaacrylate, oligoester acrylates and methacrylates, glycerol di- and tri-acrylate, 1,4-cyclohexane diacrylate, bisacrylates and bismethacrylates of polyethylene glycol having a molecular weight of from 200 to 1500, and mixtures thereof.

Also suitable as component (a1, a2) are the amides of identical or different unsaturated carboxylic acids and aromatic, cycloaliphatic and aliphatic polyamines having preferably from 2 to 6, especially from 2 to 4, amino groups. Examples of such polyamines are ethylenediamine, 1,2- or 1,3-propylenediamine, 1,2-, 1,3- or 1,4-butylenediamine, 1,5-pentylenediamine, 1,6-hexylenediamine, octylenediamine, dodecylenediamine, 1,4-diamino-cyclohexane, isophoronediamine, phenylenediamine, bisphenylenediamine, di-β-aminoethyl ether, diethylenetriamine, triethylenetetramine and di(β-aminoethoxy)- and di(β-aminopropoxy)-ethane. Further suitable polyamines are polymers and copolymers which may have additional amino groups in the side chain and oligoamides having amino terminal groups. Examples

of such unsaturated amides are: methylene bisacrylamide, 1,6-hexamethylene bisacrylamide, diethylenetriamine trismethacrylamide, bis(methacrylamidopropoxy)ethane, β-methacrylamidoethyl methacrylate and N-[(β-hydroxyethoxy) ethyl]-acrylamide.

Suitable unsaturated polyesters and polyamides are derived, for example, from maleic acid and diols or diamines. The maleic acid may have been partially replaced by other dicarboxylic acids. They may be used together with ethylenically unsaturated comonomers, e.g. styrene. The polyesters and polyamides may also be derived from dicarboxylic acids and ethylenically unsaturated diols or diamines, especially from those having longer chains of e.g. from 6 to 20 carbon atoms. Examples of polyurethanes are those composed of saturated diisocyanates and unsaturated diols or unsaturated diisocyanates and saturated diols.

Polybutadiene and polyisoprene and copolymers thereof are known. Suitable comonomers include, for example, olefins, such as ethylene, propene, butene, hexene, (meth)acrylates, acrylonitrile, styrene and vinyl chloride. Polymers having (meth)acrylate groups in the side chain are likewise known. Examples are reaction products of novolak-based epoxy resins with (meth)acrylic acid; homo- or co-polymers of vinyl alcohol or hydroxyalkyl derivatives thereof that have been esterified with (meth)acrylic acid; and homo- and co-polymers of (meth)acrylates that have been esterified with hydroxyalkyl (meth)acrylates.

The compounds of component (a1, a2) can be used on their own or in any desired mixtures. Preferably mixtures of polyol (meth)acrylates are used.

Preferred monomer, oligomer and polymer components for such mixtures are described by way of example above.

Suitable mono-, di-, tri- and higher-functional components are commercially available.

The molecular weights of the oligomers, co-oligomers, polymers or co-polymers may range from approximately 100 to 100 000, preferably from 200 to 10 000 and especially from 500 to 5000.

Preference is given to photopolymerisable mixtures that comprise one or more photoinitiators as further component. Examples of photoinitiators are given below.

As photoinitiators it is possible in principle to add any initiators known from the prior art.

Typical examples are mentioned below, which can be used both on their own or in admixture with one another. For example, benzophenones, benzophenone derivatives, acetophenone, acetophenone derivatives, e.g. α-hydroxycycloalkylphenylketones or 2-hydroxy-2-methyl-1-phenylpropanone, dialkoxyacetophenones, α-hydroxy- or α-aminoacetophenones, e.g. (4-methylthiobenzoyl)-1-methyl-1-morpholino-ethane, (4-morpholino-benzoyl)-1-benzyl-1-dimethylaminopropane, 4-aroyl-1,3-dioxolanes, benzoin alkyl ethers and benzil ketals, e.g. benzil dimethyl ketal, phenyl glyoxalates and derivatives thereof, dimeric phenylglyoxalates, monoacylphosphine oxides, e.g. (2,4,6-trimethylbenzoyl)phenylphosphine oxide, bisacylphosphine oxides, e.g. bis(2,6-dimethoxybenzoyl)-(2,4,4-trimethyl-pent-1-yl) phosphine oxide, bis(2,4,6-trimethylbenzoyl)phenylphosphine oxide or bis(2,4,6-trimethylbenzoyl)-(2,4-dipentyloxyphenyl)phosphine oxide, trisacylphosphine oxides, ferrocenium compounds or titanocenes, e.g. dicyclopentadienylbis (2,6-difluoro-3-pyrrolo-phenyl)titanium. A further class of suitable photoinitiators is that of the oxime esters. The following compounds may be mentioned by way of example: 1-(4-phenylsulfanyl-phenyl)-butane-1,2-dione 2-oxime-O-benzoate, 1-(4-phenylsulfanyl-phenyl)-octane-1,2-dione 2-oxime-O-benzoate, 1-(4-phenylsulfanyl-phenyl)-octan-1-one oxime-O-acetate, 1-(4-phenylsulfanyl-phenyl)-butan-1-one oxime-O-acetate and 1-(4-phenylsuffanyl-phenyl)-octane-1,2-dione 2-oxime-O-benzoate.

As co-initiators there come into consideration, for example, sensitisers that shift or broaden the spectral sensitivity and thus bring about an acceleration of the photopolymerisation. They are especially aromatic carbonyl compounds such as e.g. benzophenone, thioxanthone, especially isopropylthioxanthone, anthraquinone and 3-acylcoumarin derivatives, terphenyls, styryl ketones, and also 3-(aroylmethylene)-thiazolines, camphor quinone, but also eosine, rhodamine and erythrosin dyes.
Further examples of photosensitisers are

<u>1. Thioxanthones</u>

Thioxanthone, 2-isopropylthioxanthone, 2-chlorothioxanthone, 2-dodecylthioxanthone, 2,4-diethylthioxanthone, 2,4-dimethylthioxanthone, 1-methoxycarbonylthioxanthone, 2-ethoxycarbonylthioxanthone, 3-(2-methoxyethoxycarbonyl)-thioxanthone, 4-butoxycarbonylthioxanthone, 3-butoxycarbonyl-7-methylthioxanthone, 1-cyano-3-chlorothioxanthone, 1-ethoxycarbonyl-3-chlorothioxanthone, 1-ethoxycarbonyl-3-ethoxythioxanthone, 1-ethoxycarbonyl-3-aminothioxanthone, 1-ethoxycarbonyl-3-phenylsulfurylthioxanthone, 3,4-di[2-(2-methoxyethoxy)ethoxycarbonyl]thioxanthone, 1-ethoxycarbonyl-3-(1-methyl-1-morpholinoethyl)-thioxanthone, 2-methyl-6-dimethoxymethyl-thioxanthone, 2-methyl-6-(1,1-dimethoxybenzyl)-thioxanthone, 2-morpholinomethylthioxanthone, 2-methyl-6-morpholinomethylthioxanthone, N-allylthioxanthone-3,4-dicarboximide, N-octylthioxanthone-3,4-dicarboximide, N-(1,1,3,3-tetramethylbutyl)-thioxanthone-3,4-dicarboximide, 1-phenoxythioxanthone, 6-ethoxycarbonyl-2-methoxythioxanthone, 6-ethoxycarbonyl-2-methylthioxanthone, thioxanthone-2-polyethylene glycol ester, 2-hydroxy-3-(3,4-dimethyl-9-oxo-9H-thioxanthon-2-yloxy)-N,N,N-trimethyl-1-propanaminium chloride;

2. Benzophenones

Benzophenone, 4-phenylbenzophenone, 4-methoxybenzophenone, 4,4'-dimethoxybenzophenone, 4,4'-dimethylbenzophenone, 4,4'-dichlorobenzophenone, 4,4'-dimethylaminobenzophenone, 4,4'-diethylaminobenzophenone, 4-methylbenzophenone, 2,4,6-trimethylbenzophenone, 4-(4-methylthiophenyl)-benzophenone, 3,3'-dimethyl-4-methoxybenzophenone, methyl-2-benzoyl benzoate, 4-(2-hydroxyethylthio)-benzophenone, 4-(4-tolylthio)benzophenone, 4-benzoyl-N,N,N-trimethylbenzenemethanaminium chloride, 2-hydroxy-3-(4-benzoylphenoxy)-N,N,N-trimethyl-1-propanaminium chloride monohydrate, 4-(13-acryloyl-1,4,7,10,13-pentaoxatridecyl)-benzophenone, 4-benzoyl-N,N-dimethyl-N-[2-(1-oxo-2-propenyl)oxy]ethyl-benzenemethanaminium chloride;

3. 3-Acylcoumarins

3-Benzoylcoumarin, 3-benzoyl-7-methoxycoumarin, 3-benzoyl-5,7-di(propoxy)coumarin, 3-benzoyl-6,8-dichlorocoumarin, 3-benzoyl-6-chlorocoumarin, 3,3'-carbonyl-bis[5,7-di(propoxy)coumarin], 3,3'-carbonyl-bis(7-methoxycoumarin), 3,3'-carbonyl-bis(7-diethylaminocoumarin), 3-isobutyroylcoumarin, 3-benzoyl-5,7-dimethoxycoumarin, 3-benzoyl-5,7-diethoxycoumarin, 3-benzoyl-5,7-dibutoxycoumarin, 3-benzoyl-5,7-di(methoxyethoxy)-coumarin, 3-benzoyl-5,7-di(allyloxy)coumarin, 3-benzoyl-7-dimethylaminocoumarin, 3-benzoyl-7-diethylaminocoumarin, 3-isobutyroyl-7-dimethylaminocoumarin, 5,7-dimethoxy-3-(1-naphthoyl)-coumarin, 5,7-dimethoxy-3-(1-naphthoyl)-coumarin, 3-benzoylbenzo[f]-coumarin, 7-diethylamino-3-thienoylcoumarin, 3-(4-cyanobenzoyl)-5,7-dimethoxycoumarin;

4. 3-(Aroylmethylene)-thiazolines

3-Methyl-2-benzoylmethylene-β-naphthothiazoline, 3-methyl-2-benzoylmethylene-benzothiazoline, 3-ethyl-2-propionylmethylene-β-naphthothiazoline;

5. Other carbonyl compounds

Acetophenone, 3-methoxyacetophenone, 4-phenylacetophenone, benzil, 2-acetylnaphthalene, 2-naphthaldehyde, 9,10-anthraquinone, 9-fluorenone, dibenzosuberone, xanthone, 2,5-bis(4-diethylaminobenzylidene)cyclopentanone, α-(para-dimethylaminobenzylidene)ketones, such as 2-(4-dimethylamino-benzylidene)-indan-1-one or 3-(4-dimethylamino-phenyl)-1-indan-5-yl-propenone, 3-phenylthiophthalimide, N-methyl-3,5-di(ethylthio)phthalimide, N-methyl-3,5-di(ethylthio)phthalimide.

It is also possible to add non-reactive binders to the compositions according to the invention. The amount of binder may be, for example, from 5 to 40% by weight, based on the total solids. The choice of binder is made according to the field of use and the properties required therefor, such as developability in aqueous and organic solvent systems, adhesion to substrates and oxygen sensitivity.

Suitable binders are, for example, polymers having a molecular weight of approximately from 5000 to 2 000 000, preferably from 10 000 to 1 000 000. Examples are: homo- and copolymers of acrylates and methacrylates, e.g. copolymers of methyl methacrylate/ethyl acrylate/methacrylic acid, poly(methacrylic acid alkyl esters), poly(acrylic acid alkyl esters); cellulose esters and ethers, such as cellulose acetate, cellulose acetate butyrate, methylcellulose, ethylcellulose; polyvinylbutyral, polyvinylformal, cyclised caoutchouc, polyethers such as polyethylene oxide, polypropylene oxide, polytetrahydrofuran; polystyrene, polycarbonate, polyurethane, chlorinated polyolefins, polyvinyl chloride, copolymers of vinyl chloride/vinylidene chloride, copolymers of vinylidene chloride with acrylonitrile, methyl methacrylate and vinyl acetate, polyvinyl acetate, copoly(ethylene/vinyl acetate), polymers such as polycaprolactam and poly(hexamethylene adipamide), polyesters such as poly(ethylene glycol terephthalate) and poly(hexamethylene glycol succinate).

The unsaturated compounds can also be used in admixture with non-photopolymerisable film-forming components. These may be, for example, polymers that can be dried physically or solutions thereof in organic solvents, for example nitrocellulose or cellulose acetobutyrate, but they may also be chemically or thermally curable resins, for example polyisocyanates, polyepoxides or melamine resins. The concomitant use of thermally curable resins is important for use in so-called hybrid systems, which are photopolymerised in a first step and crosslinked by thermal after-treatment in a second step.

The thermocurable component is, for example, generally a film-forming binder based on a thermoplastic or thermocurable resin, predominantly on a thermocurable resin. Examples thereof are alkyd, acrylic, polyester, phenolic, melamine, epoxy and polyurethane resins and mixtures thereof. Examples thereof are described, for example, in Ullmann's Encyclopedia of Industrial Chemistry, 5th Ed., Vol. A18, pp. 368-426, VCH, Weinheim 1991.

It may be a cold-curable or hot-curable binder, with the addition of a curing catalyst possibly being advantageous. Suitable catalysts that accelerate the full cure of the binder are described, for example, in Ullmann's Encyclopedia of Industrial Chemistry, Vol. A18, page 469, VCH Verlagsgesellschaft, Weinheim 1991.

Examples of suitable specific binders are:

1. surface-coatings based on cold- or hot-crosslinkable alkyd, acrylate, polyester, epoxy or melamine resins or mixtures of such resins, optionally with the addition of a curing catalyst;
2. two-component polyurethane surface-coatings based on hydroxyl-group-containing acrylate, polyester or polyether resins and aliphatic or aromatic isocyanates, isocyanurates or polyisocyanates;
3. one-component polyurethane surface-coatings based on blocked isocyanates, isocyanurates or polyisocyanates, which are de-blocked during stoving; it is also possible to add melamine resins as appropriate;
4. one-component polyurethane surface-coatings based on aliphatic or aromatic urethanes or polyurethanes and hydroxy-group-containing acrylate, polyester or polyether resins;
5. one-component polyurethane surface-coatings based on aliphatic or aromatic urethane acrylates or polyurethane acrylates having free amine groups in the urethane structure and melamine resins or polyether resins, optionally with the addition of a curing catalyst;
6. two-component surface-coatings based on (poly)ketimines and aliphatic or aromatic isocyanates, isocyanurates or polyisocyanates;
7. two-component surface-coatings based on (poly)ketimines and an unsaturated acrylate resin or a polyacetoacetate resin or a methacrylamidoglycolate methyl ester;
8. two-component surface-coatings based on carboxy- or amino-group-containing polyacrylates and polyepoxides;
9. two-component surface-coatings based on anhydride-group-containing acrylate resins and a polyhydroxy or polyamino component;
10. two-component surface-coatings based on acrylate-containing anhydrides and polyepoxides;
11. two-component surface-coatings based on (poly)oxazolines and anhydride-group-containing acrylate resins or unsaturated acrylate resins or aliphatic or aromatic isocyanates, isocyanurates or polyisocyanates;
12. two-component surface-coatings based on unsaturated polyacrylates and polymalonates;
13. thermoplastic polyacrylate surface-coatings based on thermoplastic acrylate resins or extrinsically crosslinking acrylate resins in combination with etherified melamine resins;
14. surface-coating systems based on urethane (meth)acrylate having (meth)acryloyl groups and free isocyanate groups and on one or more compounds that react with isocyanates, for example free or esterified polyols. Such systems have been published, for example, in EP 928 800.

Blocked isocyanates, as may also be used therein, are described, for example, in Organischer Metallschutz: Entwicklung und Anwendung von Beschichtungsstoffen, pages 159-160, Vincentz Verlag, Hannover (1993). These are compounds in which the highly reactive NCO group is "blocked" by reaction with specific radicals, for example primary alcohols, phenol, acetoacetic ester, ε-caprolactam, phthalimide, imidazole, oxime or amine. The blocked isocyanate is stable in liquid systems and also in the presence of hydroxy groups. On heating, the blocking agents are removed again and the NCO group is freed.

Both 1-Component (1C) and 2-component (2C) systems may be used. Examples of such systems are described in Ullmann's Encyclopedia of Industrial Chemistry, Vol. A18, Paints and Coatings, pages 404-407, VCH Verlagsgesellschaft mbH, Weinheim (1991).

It is possible to optimise the composition by specially adapting the formulation, for example by varying the binder/crosslinking agent ratio. Such measures will be known to the person skilled in the art of surface-coating technology.

Preferred as thermocurable component is a mixture based on acrylate/melamine (and melamine derivatives), 2-component polyurethane, 1-component polyurethane, 2-component epoxy/carboxy or 1-component epoxy/carboxy. Mixtures of those systems are also possible, for example the addition of melamine (or derivatives thereof) to 1-component polyurethanes.

Special preference is given to a binder based on a polyacrylate with melamine or a melamine derivative. Also preferred is a system based on a polyacrylate or/and polyester polyol with a non-blocked polyisocyanate or polyisocyanurate.

Also included are compositions comprising as component (a1, a2) at least one ethylenically unsaturated photopolymerisable compound dissolved or emulsified in water. Such aqueous radiation-curable prepolymer dispersions are commercially available in many variations and are described in the literature. They are to be understood as being dispersions consisting of water and at least one prepolymer dispersed therein. The concentration of water in such systems is, for example, from 5 to 80% by weight, especially from 30 to 60% by weight. The radiation-curable prepolymer

or mixture of prepolymers is present, for example, in concentrations of from 95 to 20% by weight, especially from 70 to 40% by weight. In such compositions the sum of the percentages mentioned for water and prepolymer will be 100 in each case, the auxiliaries and additives, which will be present in varying amounts in accordance with the intended use, being in addition thereto.

The radiation-curable film-forming prepolymers, which are dispersed or in many cases dissolved in water, are mono- or poly-functional ethylenically unsaturated prepolymers that can be initiated by free radicals, for example such as those described above, which prepolymers are known *per se* for aqueous prepolymer dispersions and contain, for example, from 0.01 to 1.0 mol of polymerisable double bonds per 100 g of prepolymer and have an average molecular weight of, for example, at least 400, especially of from 500 to 10 000. Prepolymers having higher molecular weights may also be suitable, however, depending upon the intended use.

There are used, for example, polymerisable C-C double-bond-containing polyesters having an acid number of a maximum of 10, polymerisable C-C double-bond-containing polyethers, hydroxyl-group-containing reaction products of a polyepoxide containing at least two epoxy groups per molecule with at least one α,β-ethylenically unsaturated carboxylic acid, polyurethane (meth)acrylates and acrylic copolymers containing α,β-ethylenically-unsaturated acrylic radicals, as described in EP 12 339. Mixtures of those prepolymers may also be used. Also suitable are the polymerisable prepolymers described in EP 33 896, which are thioether adducts of polymerisable prepolymers having an average molecular weight of at least 600, a carboxyl group content of from 0.2 to 15% and a content of from 0.01 to 0.8 mol of polymerisable C-C double bonds per 100 g of prepolymer. Other suitable aqueous dispersions based on specific (meth)acrylic acid alkyl ester polymerisation products are described in EP 41 125, and suitable water-dispersible radiation-curable prepolymers of urethane acrylates can be found in DE 2 936 039. Further descriptions of aqueous radiation-curable formulations have been published, for example, by H. Lange in Farbe+Lack, Vol. 99, 7/93, pages 597-601 and W. Reich, K. Menzel and W. Schrof in Farbe+Lack, Vol. 104, 12/98, pages 73-80.

As further additives the radiation-curable aqueous prepolymer dispersions may comprise dispersing agents, emulsifiers, anti-oxidants, light stabilisers, dyes, pigments, fillers, e.g. talc, gypsum, silicic acid, rutile, carbon black, zinc oxide, iron oxides, reaction accelerators, flow agents, glidants, wetting agents, thickeners, matting agents, antifoams and other adjuvants customary in surface-coating technology. Suitable dispersing agents include water-soluble high molecular weight organic compounds having polar groups, e.g. polyvinyl alcohols, polyvinylpyrrolidone and cellulose ethers. As emulsifiers it is possible to use nonionic and, where appropriate, ionic emulsifiers.

The photopolymerisable monomers, oligomers, co-oligomers, polymers or copolymers containing at least one ethylenically unsaturated bond can, when formulated as mixtures, be formulated for very specific uses. Examples are clear lacquers, printing inks, pigmented surface-coatings, etch resists or solder resists in the semiconductor industry.

Further additives may also be present according to the intended use.

For example, in addition to the stabilisers (b) according to the invention, further stabilisers, e.g. hydroquinone, p-methoxyphenol, β-naphthol or sterically hindered phenols, such as 2,6-di(tert-butyl)-p-cresol, may be present.

The formulations may also contain as additional additives dyes and/or white or coloured pigments. Depending upon the intended use, both inorganic and organic pigments may be used. Such additives will be known to the person skilled in the art; some examples are titanium dioxide pigments, e.g. of the rutile or anatase type, carbon black, zinc oxide, such as zinc white, iron oxides, such as iron oxide yellow, iron oxide red, chromium yellow, chromium green, nickel titanium yellow, ultramarine blue, cobalt blue, bismuth vanadate, cadmium yellow and cadmium red. Examples of organic pigments are mono- or bis-azo pigments, and also metal complexes thereof, phthalocyanine pigments, polycyclic pigments, e.g. perylene, anthraquinone, thioindigo, quinacridone or triphenylmethane pigments, and also diketo-pyrrolo-pyrrole, isoindolinone, e.g. tetrachloroisoindolinone, isoindoline, dioxazine, benzimidazolone and quinophthalone pigments.

The pigments may be used in the formulations on their own or in admixture.

Depending upon the intended use, the pigments are added to the formulations in amounts customary in the art, for example in an amount of from 0.1 to 60% by weight, e.g. from 1 to 60% by weight, for example 10 to 50 or 10 to 40% by weight, based on the total mass.

The formulations may also comprise, for example, organic dyes of an extremely wide variety of classes. Examples are azo dyes, methine dyes, anthraquinone dyes and metal complex dyes. Customary concentrations are, for example, from 0.1 to 20%, especially from 1 to 5%, based on the total mass.

In addition to the additives mentioned above, the composition may also comprise further additives, especially light stabilisers.

Examples thereof are listed below.

<u>UV Absorbers and light stabilisers</u>

<u>1,2-(2'-Hydroxyphenyl)-benzotriazoles</u>, e.g. 2-(2'-hydroxy-5'-methylphenyl)-benzotriazole, 2-(3',5'-di-tert-butyl-2'-hydroxyphenyl)-benzotriazole, 2-(5'-tert-butyl-2'-hydroxyphenyl)-benzotriazole, 2-(2'-hydroxy-5'-(1,1,3,3-tetramethylbutyl)-phenyl)-benzotriazole, 2-(3',5'-di-tert-butyl-2' -hydroxyphenyl)-5-chlorobenzotriazole, 2-(3'-tert-butyl-2'-hydroxy-5'-methylphenyl)-5-chlorobenzotriazole, 2-(3'-sec-butyl-5'-tert-butyl-2'-hydroxyphenyl)-benzotriazole, 2-(2'-hydroxy-4'-octyloxyphenyl)-benzotriazole, 2-(3',5'-di-tert-amyl-2'-hydroxyphenyl)-benzotriazole, 2-(3',5'-bis(α,α-dimethylbenzyl)-2'-hydroxyphenyl)benzotriazole, 2-(3'-tert-butyl-2'-hydroxy-5'-(2-octyloxycarbonylethyl)phenyl)-5-chlorobenzotriazole, 2-(3-tert-butyl-5'-[2-(2-ethylhexyloxy)carbonylethyl]-2'-hydroxyphenyl)-5-chlorobenzotriazole, 2-(3'-tert-butyl-2'-hydroxy-5'-(2-methoxycarbonylethyl)phenyl)-5-chlorobenzotriazole, 2-(3'-tert-butyl-2'-hydroxy-5'-(2-methoxycarbonylethyl)phenyl)-benzotriazole, 2-(3'-tert-butyl-2'-hydroxy-5'-(2-octyloxycarbonylethyl)phenyl)-benzotriazole, 2-(3'-tert-butyl-5'-[2-(2-ethyhexyloxy)carbonylethyl]-2'-hydroxyphenyl)-benzotriazole, 2-(3'-dodecyl-2'-hydroxy-5'-methylphenyl)-benzo triazole, 2-(3'-tert-butyl-2'-hydroxy-5'-(2-isooctyloxycarbonylethyl)-phenyl-benzotriazole, 2,2'-methylene-bis[4-(1,1,3,3-tetramethylbutyl)-6-benzotriazol-2-yl-phenol]; the transesterification product of 2-[3'-tert-butyl-5'-(2-methoxycarbonylethyl)-2'-hydroxyphenyl]-benzotriazole with polyethylene glycol 300;

$$[R-CH_2CH_2-COO-CH_2CH_2]_2$$

wherein R = 3'-tert-butyl-4'-hydroxy-5'-2H-benzotriazol-2-yl-phenyl; 2-[2'-hydroxy-3'-(α,α-dimethylbenzyl)-5'-(1,1,3,3-tetramethylbutyl)-phenyl]-benzotriazole; 2-[2'-hydroxy-3'-(1,1,3,3-tetramethylbutyl)-5'-(α,α-dimethylbenzyl)-phenyl]-benzotriazole.

2. Hydroxybenzophenones, e.g the 4-hydroxy, 4-methoxy, 4-octyloxy, 4-decyloxy, 4-dodecyloxy, 4-benzyloxy, 4,2',4'-trihydroxy or 2'-hydroxy-4,4'-dimethoxy derivative.

3. Esters of unsubstituted or substituted benzoic acids, e.g. 4-tert-butyl-phenyl salicylate, phenyl salicylate, octylphenyl salicylate, dibenzoylresorcinol, bis(4-tert-butylbenzoyl)-resorcinol, benzoylresorcinol, 3,5-di-tert-butyl-4-hydroxybenzoic acid 2,4-di-tert-butylphenyl ester, 3,5-di-tert-butyl-4-hydroxybenzoic acid hexadecyl ester, 3,5-di-tert-butyl-4-hydroxybenzoic acid octadecyl ester and 3,5-di-tert-butyl-4-hydroxybenzoic acid 2-methyl-4,6-di-tert-butylphenyl ester.

4. Acrylates, e.g. α-cyano-β,β-diphenylacrylic acid ethyl ester or isooctyl ester, α-methoxy-carbonylcinnamic acid methyl ester, α-cyano-β-methyl-p-methoxycinnamic acid methyl ester or butyl ester, α-methoxycarbonyl-p-methoxycinnamic acid methyl ester and N-(β-methoxy-carbonyl-β-cyanovinyl)-2-methyl-indoline.

5. Sterically hindered amines, for example bis(2,2,6,6-tetramethyipiperidin-4-yl) sebacate, bis(2,2,6,6-tetramethylpiperidin-4-yl) succinate, bis(1,2,2,6,6-pentamethylpiperidin-4-yl) sebacate, bis(1-octyloxy-2,2,6,6-tetramethylpiperidin-4-yl) sebacate, n-butyl-3,5-di-tert-butyl-4-hydroxybenzylmalonic acid bis(1,2,2,6,6-pentamethylpiperidyl) ester, condensation product of 1-hydroxyethyl-2,2,6,6-tetramethyl-4-hydroxypiperidine and succinic acid, linear or cyclic condensation products of N,N'-bis(2,2,6,6-tetramethyl-4-piperidyl)hexamethylenediamine and 4-tert-octylamino-2,6-dichloro-1,3,5-s-triazine, tris(2,2,6,6-tetramethyl-4-piperidyl) nitrilotriacetate, tetrakis(2,2,6,6-tetramethyl-4-piperidyl) 1,2,3,4-butanetetraoate, 1,1'-(1,2-ethanediyl)bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidyl)-2-n-butyl-2-(2-hydroxy-3,5-di-tert-butylbenzyl) malonate, 3-n-octyl-7,7,9,9-tetramethyl-1,3,8-triazaspiro-[4.5]decane-2,4-dione, bis(1-octyloxy-2,2,6,6-tetramethylpiperidyl) sebacate, bis(1-octyloxy-2,2,6,6-tetramethylpiperidyl) succinate, linear or cyclic condensation products of N,N'-bis(2,2,6,6-tetramethyl-4-piperidyl)hexamethylenediamine and 4-morpholino-2,6-dichloro-1,3,5-triazine, condensation product of 2-chloro-4,6-di(4-n-butylamino-2,2,6,6-tetramethylpiperidyl)-1,3,5-triazine and 1,2-bis(3-aminopropylamino)ethane, condensation product of 2-chloro-4,6-di(4-n-butylamino-1,2,2,6,6-pentamethylpiperidyl)-1,3,5-triazine and 1,2-bis(3-aminopropylamino)ethane, 8-acetyl-3-dodecyl-7,7,9,9-tetramethyl-1,3,8-triazaspiro-[4.5]decane-2,4-dione, 3-dodecyl-1-(2,2,6,6-tetramethyl-4-piperidyl)pyrrolidine-2,5-dione, 3-dodecyl-1-(1,2,2,6,6-pentamethyl-4-piperidyl)pyrrolidine-2,5-dione, mixture of 4-hexadecyloxy- and 4-stearyloxy-2,2,6,6-tetramethylpiperidine, condensation product of N,N'-bis(2,2,6,6-tetramethyl-4-piperidyl)hexamethylenediamine and 4-cyclohexylamino-2,6-dichloro-1,3,5-triazine, condensation product of 1,2-bis(3-aminopropylamino)ethane and 2,4,6-trichloro-1,3,5-triazine and 4-butylamino-2,2,6,6-tetramethylpiperidine (CAS Reg. No. [136504-96-6]); N-(2,2,6,6-tetramethyl-4-piperidyl)-n-dodecylsuccinimide, N-(1,2,2,6,6-pentamethyl-4-piperidyl)-n-dodecylsuccinimide, 2-undecyl-7,7,9,9-tetramethyl-1-oxa-3,8-diaza-4-oxo-spiro[4.5]decane, reaction product of 7,7,9,9-tetramethyl-2-cycloundecyl-1-oxa-3,8-diaza-4-oxospiro[4.5]decane and epichlorohydrin, 1,1-bis(1,2,2,6,6-pentamethyl-4-piperidyloxycarbonyl)-2-(4-methoxyphenyl)ethene, N,N'-bis-formyl-N,N'-bis(2,2,6,6-tetramethyl-4-piperidyl)hexamethylenediamine, diester of 4-methoxymethylenemalonic acid with 1,2,2,6,6-pentamethyl-4-hydroxypiperidine, poly[methylpropyl-3-oxy-4-(2,2,6,6-tetramethyl-4-piperidyl)]siloxane, reaction product of maleic anhydride α-olefin copolymer and 2,2,6,6-tetramethyl-4-aminopiperidine or 1,2,2,6,6-pentamethyl-4-aminopiperidine.

6. Oxalic acid diamides, for example 4,4'-dioctyloxy oxanilide, 2,2'-diethoxy oxanilide, 2,2'-dioctyloxy-5,5'-di-tert-butyl oxanilide, 2,2'-didodecyloxy-5,5'-di-tert-butyl oxanilide, 2-ethoxy-2'-ethyl oxanilide, N,N'-bis(3-dimethylaminopropyl) oxalamide, 2-ethoxy-5-tert-butyl-2'-ethyl oxanilide and a mixture thereof with 2-ethoxy-2'-ethyl-5,4'-di-tert-butyl oxanilide, mixtures of o- and p-methoxy- and also of o- and p-ethoxy-di-substituted oxanilides.

7. 2-(2-Hydroxyphenyl)-1,3,5-triazines, for example 2,4,6-tris(2-hydroxy-4-octyloxyphenyl)-1,3,5-triazine, 2-(2-hydroxy-4-octyloxyphenyl)-4,6-bis(2,4-dimethylphenyl)-1,3,5-triazine, 2-(2,4-dihydroxyphenyl)-4,6-bis(2,4-dimethylphenyl)-1,3,5-triazine, 2,4-bis(2-hydroxy-4-propyloxyphenyl)-6-(2,4-dimethylphenyl)-1,3,5-triazine, 2-(2-hydroxy-4-octyloxyphenyl)-4,6-bis(4-methylphenyl)-1,3,5-triazine, 2-(2-hydroxy-4-dodecyloxyphenyl)-4,6-bis(2,4-dimethylphenyl)-1,3,5-triazine, 2-(2-hydroxy-4-tridecyloxyphenyl)-4,6-bis(2,4-dimethylphenyl)-1,3,5-triazine, 2-[2-hydroxy-4-(2-hydroxy-3-butyloxypropyloxy)phenyl]-4,6-bis(2,4-dimethylphenyl)-1,3,5-triazine, 2-[2-hydroxy-4-(2-hydroxy-3-octyloxypropyloxy)phenyl]-4,6-bis(2,4-dimethylphenyl)-1,3,5-triazine, 2-[4-(dodecyloxy/tridecyloxy-2-hydroxypropoxy)-2-hydroxyphenyl]-4,6-bis(2,4-dimethylphenyl)-1,3,5-triazine, 2-[2-hydroxy-4-(2-hydroxy-3-dodecyloxypropoxy)-phenyl]-4,6-bis(2,4-dimethylphenyl)-1,3,5-triazine, 2-(2-hydroxy-4-hexyloxy)phenyl-4,6-diphenyl-1,3,5-triazine, 2-(2-hydroxy-4-methoxyphenyl)-4,6-diphenyl-1,3,5-triazine, 2,4,6-tris[2-hydroxy-4-(3-butoxy-2-hydroxypropoxy)phenyl]-1,3,5-triazine, 2-(2-hydroxyphenyl)-4-(4-methoxyphenyl)-6-phenyl-1,3,5-triazine, 2-{2-hydroxy-4-[3-(2-ethylhexyl-1-oxy)-2-hydroxypropyloxy]phenyl}-4,6-bis(2,4-dimethylphenyl)-1,3,5-triazine.

Such light stabilisers are preferably added in an amount of from 0.01 to 5% by weight, based on component (a).

The stable sterically hindered nitroxyl free-radicals (b) have the following structural feature,

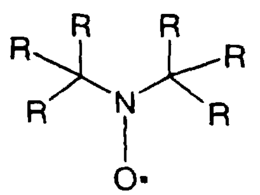

or

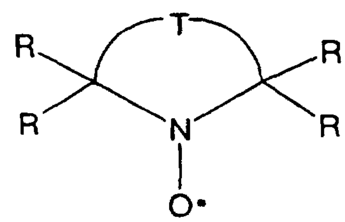

wherein R is alkyl and T is a group required to complete a 5- or 6-membered ring.

R is preferably $C_1$-$C_4$alkyl, especially methyl, when it is a cyclic nitroxyl free-radical.

Two or more nitroxyl groups in the same molecule can be linked to one another by way of the group T, as shown below. E has the meaning of a spacer group such as for example a $C_1$-$C_{12}$alkylene group.

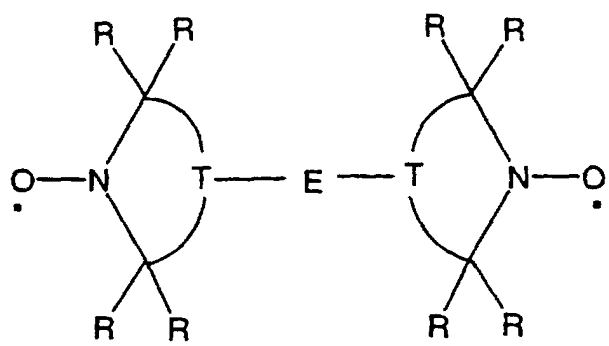

Typical nitroxyl free-radicals are, for example:
bis(1-oxy-2,2,6,6-tetramethylpiperidin-4-yl) sebacate, 4-hydroxy-1-oxy-2,2,6,6-tetramethylpiperidine, 4-ethoxy-1-oxy-2,2,6,6-tetramethylpiperidine, 4-propoxy-1-oxy-2,2,6,6-tetramethylpiperidine, 4-acetamido-1-oxy-2,2,6,6-tetramethylpiperidine, 1-oxy-2,2,6,6-tetramethylpiperidine, 1-oxy-2,2,6,6-tetramethylpiperidin-4-one, 1-oxy-2,2,6,6-tetramethylpiperidin-4-yl acetate, 1-oxy-2,2,6,6-tetramethylpiperidin-4-yl 2-ethylhexanoate, 1-oxy-2,2,6,6-tetramethylpiperidin-4-yl stearate, 1-oxy-2,2,6,6-tetramethylpiperidin-4-yl benzoate, 1-oxy-2,2,6,6-tetramethylpiperidin-4-yl 4-tert-butylbenzoate, bis(1-oxy-2,2,6,6-tetramethylpiperidin-4-yl) succinate, bis(1-oxy-2,2,6,6-tetramethylpiperidin-4-yl) adipate, bis(1-oxy-2,2,6,6-tetramethylpiperidin-4-yl) n-butylmalonate, bis(1-oxy-2,2,6,6-tetramethylpiperidin-4-yl) phthalate, bis (1-oxy-2,2,6,6-tetramethylpiperidin-4-yl) isophthalate, bis(1-oxy-2,2,6,6-tetramethylpiperidin-4-yl) terephthalate, bis (1-oxy-2,2,6,6-tetramethylpiperidin-4-yl) hexahydroterephthalate, N,N'-bis(1-oxy-2,2,6,6-tetramethylpiperidin-4-yl)adipamide, N-(1-oxy-2,2,6,6-tetramethylpiperidin-4-yl)caprolactam, N-(1-oxy-2,2,6,6-tetramethylpiperidin-4-yl)-dodecylsuccinimide, 2,4,6-tris[N-butyl-N-(1-oxy-2,2,6,6-tetramethylpiperidin-4-yl)]-s-triazine, 4,4'-ethylenebis(1-oxy-2,2,6,6-tetramethylpiperazin-3-one), 2-oxy-1,1,3,3-tetramethyl-2-isobenzazole, 1-oxy-2,2,5,5-tetramethylpyrrolidine and N,N-bis(1,1,3,3-tetramethylbutyl)-nitroxide.

Preferred nitroxyl free-radicals are: bis(1-oxy-2,2,6,6-tetramethylpiperidin-4-yl) sebacate, 4-hydroxy-1-oxy-2,2,6,6-tetramethylpiperidine, 4-ethoxy-1-oxy-2,2,6,6-tetramethylpiperidine, 4-propoxy-1-oxy-2,2,6,6-tetramethylpiperidine, 4-acetamido-1-oxy-2,2,6,6-tetramethylpiperidine, 1-oxy-2,2,6,6-tetramethylpiperidine and 1-oxy-2,2,6,6-tetramethylpiperidin-4-one.

Bis(1-oxy-2,2,6,6-tetramethylpiperidin-4-yl) sebacate and 4-hydroxy-1-oxy-2,2,6,6-tetramethylpiperidine are especially preferred.

The benzofuran-2-ones of component (b) are preferably compounds of formula (I)

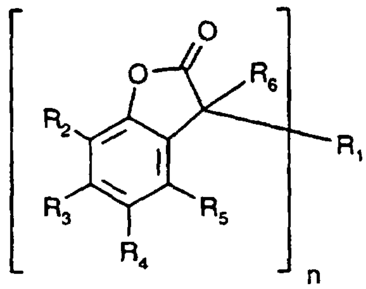

(I),

wherein, when n is 1,

$R_1$ is naphthyl, phenanthryl, anthryl, 5,6,7,8-tetrahydro-2-naphthyl, 5,6,7,8-tetrahydro-1-naphthyl, thienyl, benzo[b]thienyl, naphtho[2,3-b]thienyl, thianthrenyl, dibenzofuryl, chromenyl, xanthenyl, phenoxathiinyl, pyrrolyl, imidazolyl, pyrazolyl, pyrazinyl, pyrimidinyl, pyridazinyl, indolizinyl, isoindolyl, indolyl, indazolyl, purinyl, quinolizinyl, isoquinolyl, quinolyl, phthalazinyl, naphthyridinyl, quinoxalinyl, quinazolinyl, cinnolinyl, pteridinyl, carbazolyl, β-carbolinyl, phenanthridinyl, acridinyl, perimidinyl, phenanthrolinyl, phenazinyl, isothiazolyl, phenothiazinyl, isoxazolyl, furazanyl, biphenyl, terphenyl, fluorenyl or phenoxazinyl, each unsubstituted or substituted by $C_1$-$C_4$alkyl, $C_1$-$C_4$alkoxy, $C_1$-$C_4$alkylthio, hydroxy, halogen, amino, $C_1$-$C_4$alkylamino, phenylamino or by di($C_1$-$C_4$alkyl)amino, or $R_1$ is a radical of formula II

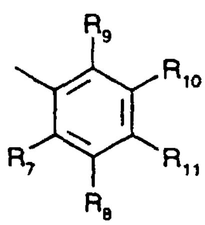

(II)

and
when n is 2,

$R_1$ is phenylene or naphthylene, each unsubstituted or substituted by $C_1$-$C_4$alkyl or by hydroxy; or is -$R_{12}$-X-$R_{13}$-,

$R_2$, $R_3$, $R_4$ and $R_5$ are each independently of the others hydrogen, chlorine, hydroxy, $C_1$-$C_{25}$alkyl, $C_7$-$C_9$phenylalkyl, unsubstituted or $C_1$-$C_4$alkyl-substituted phenyl; unsubstituted or $C_1$-$C_4$alkyl-substituted $C_5$-$C_8$cycloalkyl; $C_1$-$C_{18}$alkoxy, $C_1$-$C_{18}$alkylthio, $C_1$-$C_4$alkylamino, di($C_1$-$C_4$alkyl)amino, $C_1$-$C_{25}$alkanoyloxy, $C_1$-$C_{25}$alkanoylamino, $C_3$-$C_{25}$alkenoyloxy,

$C_3$-$C_{25}$alkanoyloxy interrupted by oxygen, sulfur or by $>$N-$R_{14}$ ; $C_6$-$C_9$cycloalkylcarbonyloxy, benzoyloxy or $C_1$-$C_{12}$alkyl-substituted benzoyloxy; or the radicals $R_2$ and $R_3$ or the radicals $R_3$ and $R_4$ or the radicals $R_4$ and $R_5$ together with the carbon atoms to which they are bonded form a benzo ring, or $R_4$ may additionally be $-(CH_2)_p-COR_{15}$ or $-(CH_2)_qOH$, or when $R_3$, $R_5$ and $R_6$ are hydrogen, $R_4$ may additionally be a radical of formula III

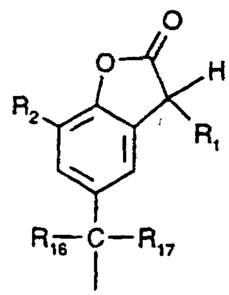

(III)

wherein $R_1$ is as defined above for n = 1,
$R_6$ is hydrogen or a radical of formula IV

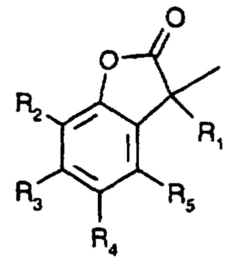

(IV),

wherein $R_4$ is not a radical of formula III and $R_1$ is as defined above for n = 1,
$R_7$, $R_8$, $R_9$, $R_{10}$ and $R_{11}$ are each independently of the others hydrogen, halogen, hydroxy, $C_1$-$C_{25}$alkyl, $C_2$-$C_{25}$alkyl interrupted by oxygen, sulfur or by $\rangle$N-$R_{14}$ ; $C_1$-$C_{25}$alkoxy,
$C_2$-$C_{25}$alkoxy interrupted by oxygen, sulfur or by $\rangle$N-$R_{14}$ ; $C_1$-$C_{25}$alkylthio, $C_3$-$C_{25}$alkenyl,
$C_3$-$C_{25}$alkenyloxy, $C_3$-$C_{25}$alkynyl, $C_3$-$C_{25}$alkynyloxy, $C_7$-$C_9$phenylalkyl, $C_7$-$C_9$phenylalkoxy, unsubstituted or $C_1$-$C_4$alkyl-substituted phenyl; unsubstituted or $C_1$-$C_4$alkyl-substituted phenoxy; unsubstituted or $C_1$-$C_4$alkyl-substituted $C_5$-$C_8$cycloalkyl; unsubstituted or $C_1$-$C_4$alkyl-substituted $C_5$-$C_8$cycloalkoxy; $C_1$-$C_4$alkylamino, di($C_1$-$C_4$alkyl)amino,
$C_1$-$C_{25}$alkanoyl, $C_3$-$C_{25}$alkanoyl interrupted by oxygen, sulfur or by $\rangle$N-$R_{14}$ ;
$C_1$-$C_{25}$alkanoyloxy, $C_3$-$C_{25}$alkanoyloxy interrupted by oxygen, sulfur or by $\rangle$N-$R_{14}$ ;
$C_1$-$C_{25}$alkanoylamino, $C_3$-$C_{25}$alkenoyl, $C_3$-$C_{25}$alkenoyl interrupted by oxygen, sulfur or by $\rangle$N-$R_{14}$ ; $C_3$-$C_{25}$alkenoyloxy, $C_3$-$C_{25}$alkenoyloxy interrupted by oxygen, sulfur or by $\rangle$N-$R_{14}$ ; $C_6$-$C_9$cycloalkylcarbonyl, $C_6$-$C_9$cycloalkylcarbonyloxy, benzoyl or $C_1$-$C_{12}$alkyl-substituted benzoyl; benzoyloxy or $C_1$-$C_{12}$alkyl-substituted benzoyloxy;

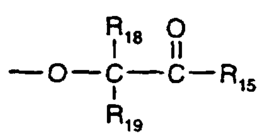 or 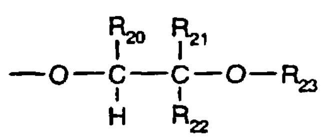 ,

or in formula II the radicals $R_7$ and $R_8$ or the radicals $R_8$ and $R_{11}$ together with the carbon atoms to which they are bonded form a benzo ring,
$R_{12}$ and $R_{13}$ are each independently of the other unsubstituted or $C_1$-$C_4$alkyl-substituted phenylene or naphthylene,
$R_{14}$ is hydrogen or $C_1$-$C_8$alkyl,
$R_{15}$ is hydroxy,

$$\left[-O^{-}\ \frac{1}{r}M^{r+}\right] ,$$

$C_1$-$C_{18}$alkoxy or

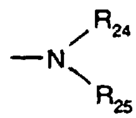

$R_{16}$ and $R_{17}$ are each independently of the other hydrogen, $CF_3$, $C_1$-$C_{12}$alkyl or phenyl, or $R_{16}$ and $R_{17}$ together with the carbon atom to which they are bonded form a $C_5$-$C_8$cycloalkylidene ring that is unsubstituted or substituted by from 1 to 3 $C_1$-$C_4$alkyl groups;
$R_{18}$ and $R_{19}$ are each independently of the other hydrogen, $C_1$-$C_4$alkyl or phenyl,
$R_{20}$ is hydrogen or $C_1$-$C_4$alkyl,
$R_{21}$ is hydrogen, unsubstituted or $C_1$-$C_4$alkyl-substituted phenyl; $C_1$-$C_{25}$alkyl, $C_2$-$C_{25}$alkyl interrupted by oxygen, sulfur or by $>$N-$R_{14}$ ; $C_7$-$C_9$phenylalkyl that is unsubstituted or substituted on the phenyl radical by from 1 to 3 $C_1$-$C_4$alkyl groups; $C_7$-$C_{25}$phenylalkyl that is unsubstituted or substituted on the phenyl radical by from 1 to 3 $C_1$-$C_4$alkyl groups and interrupted by oxygen, sulfur or by $>$N-$R_{14}$ , or the radicals $R_{20}$ and $R_{21}$ together with the carbon atoms to which they are bonded form a $C_5$-$C_{12}$cycloalkylene ring that is unsubstituted or substituted by from 1 to 3 $C_1$-$C_4$alkyl groups;
$R_{22}$ is hydrogen or $C_1$-$C_4$alkyl,
$R_{23}$ is hydrogen, $C_1$-$C_{25}$alkanoyl, $C_3$-$C_{25}$alkenoyl, $C_3$-$C_{25}$alkanoyl interrupted by oxygen, sulfur or by $>$N-$R_{14}$ ; $C_2$-$C_{25}$alkanoyl substituted by a di($C_1$-$C_6$alkyl)phosphonate group; $C_6$-$C_9$cycloalkylcarbonyl, thenoyl, furoyl, benzoyl or $C_1$-$C_{12}$alkyl-substituted benzoyl;

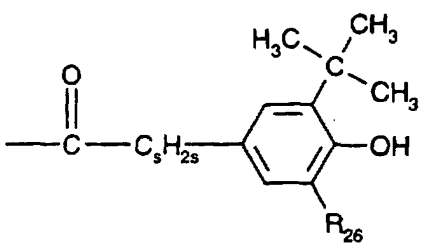 , 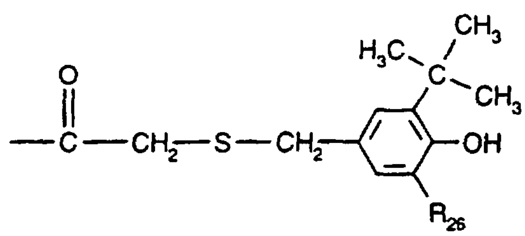 ,

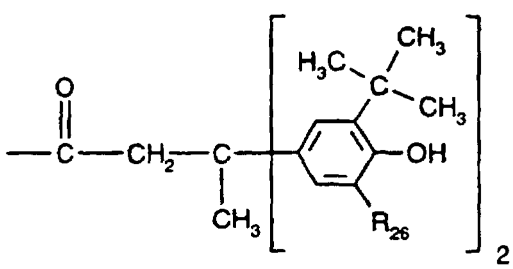 , 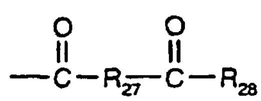 or 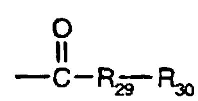 ,

$R_{24}$ and $R_{25}$ are each independently of the other hydrogen or $C_1$-$C_{18}$alkyl,
$R_{26}$ is hydrogen or $C_1$-$C_8$alkyl,
$R_{27}$ is a direct bond, $C_1$-$C_{18}$alkylene, $C_2$-$C_{18}$alkylene interrupted by oxygen, sulfur or by $>$N-$R_{14}$ ; $C_2$-$C_{18}$alkenylene, $C_2$-$C_{20}$alkylidene, $C_7$-$C_{20}$phenylalkylidene, $C_5$-$C_8$cycloalkylene, $C_7$-$C_8$bicycloalkylene, unsubstituted or $C_1$-$C_4$alkyl-substituted phenylene,

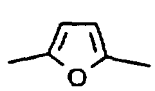 or 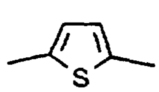 ,

$R_{28}$ is hydroxy,

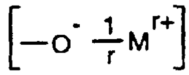 ,

$C_1$-$C_{18}$alkoxy or

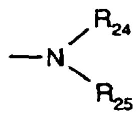 ,

$R_{29}$ is oxygen, -NH- or

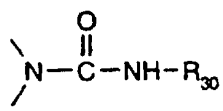 ,

$R_{30}$ is $C_1$-$C_{18}$alkyl or phenyl,
$R_{31}$ is hydrogen or $C_1$-$C_{18}$alkyl,
M is an r-valent metal cation,
X is a direct bond, oxygen, sulfur or -$NR_{31}$-,
n is 1 or 2,
p is 0, 1 or 2,
q is 1, 2, 3, 4, 5 or 6,
r is 1, 2 or 3, and
s is 0, 1 or 2.

Naphthyl, phenanthryl, anthryl, 5,6,7,8-tetrahydro-2-naphthyl, 5,6,7,8-tetrahydro-1-naphthyl, thienyl, benzo [b]thienyl, naphtho[2,3-b]thienyl, thianthrenyl, dibenzofuryl, chromenyl, xanthenyl, phenoxathiinyl, pyrrolyl, imidazolyl, pyrazolyl, pyrazinyl, pyrimidinyl, pyridazinyl, indolizinyl, isoindolyl, indolyl, indazolyl, purinyl, quinolizinyl, isoquinolyl, quinolyl, phthalazinyl, naphthyridinyl, quinoxalinyl, quinazolinyl, cinnolinyl, pteridinyl, carbazolyl, β-carbolinyl, phenanthridinyl, acridinyl, perimidinyl, phenanthrolinyl, phenazinyl, isothiazolyl, phenothiazinyl, isoxazolyl, furazanyl, biphenyl, terphenyl, fluorenyl or phenoxazinyl, each unsubstituted or substituted by $C_1$-$C_4$alkyl, $C_1$-$C_4$alkoxy, $C_1$-$C_4$alkylthio, hydroxy, halogen, amino, $C_1$-$C_4$alkylamino, phenylamino or by di($C_1$-$C_4$alkyl)amino, is, for example, 1-naphthyl, 2-naphthyl, 1-phenylamino-4-naphthyl, 1-methylnaphthyl, 2-methylnaphthyl, 1-methoxy-2-naphthyl, 2-methoxy-1-naphthyl, 1-dimethylamino-2-naphthyl, 1,2-dimethyl-4-naphthyl, 1,2-dimethyl-6-naphthyl, 1,2-dimethyl-7-naphthyl, 1,3-dimethyl-6-naphthyl, 1,4-dimethyl-6-naphthyl, 1,5-dimethyl-2-naphthyl, 1,6-dimethyl-2-naphthyl, 1-hydroxy-2-naphthyl, 2-hydroxy-1-naphthyl, 1,4-dihydroxy-2-naphthyl, 7-phenanthryl, 1-anthryl, 2-anthryl, 9-anthryl, 3-benzo[b] thienyl, 5-benzo[b]thienyl, 2-benzo[b]thienyl, 4-dibenzofuryl, 4,7-dibenzofuryl, 4-methyl-7-dibenzofuryl, 2-xanthenyl, 8-methyl-2-xanthenyl, 3-xanthenyl, 2-phenoxathiinyl, 2,7-phenoxathiinyl, 2-pyrrolyl, 3-pyrrolyl, 5-methyl-3-pyrrolyl, 2-imidazolyl, 4-imidazolyl, 5-imidazolyl, 2-methyl-4-imidazolyl, 2-ethyl-4-imidazolyl, 2-ethyl-5-imidazolyl, 3-pyrazolyl, 1-methyl-3-pyrazolyl, 1-propyl-4-pyrazolyl, 2-pyrazinyl, 5,6-dimethyl-2-pyrazinyl, 2-indolizinyl, 2-methyl-3-isoindolyl, 2-methyl-1-isoindolyl, 1-methyl-2-indolyl, 1-methyl-3-indolyl, 1,5-dimethyl-2-indolyl, 1-methyl-3-indazolyl, 2,7-dimethyl-8-purinyl, 2-methoxy-7-methyl-8-purinyl, 2-quinolizinyl, 3-isoquinolyl, 6-isoquinolyl, 7-isoquinolyl, isoquinolyl, 3-methoxy-6-isoquinolyl, 2-quinolyl, 6-quinolyl, 7-quinolyl, 2-methoxy-3-quinolyl, 2-methoxy-6-quinolyl, 6-phthalazinyl, 7-phthalazinyl, 1-methoxy-6-phthalazinyl, 1,4-dimethoxy-6-phthalazinyl, 1,8-naphthyridin-2-yl, 2-quinoxalinyl, 6-quinoxalinyl, 2,3-dimethyl-6-quinoxalinyl, 2,3-dimethoxy-6-quinoxalinyl, 2-quinazolinyl, 7-quinazolinyl, 2-dimethylamino-6-quinazolinyl, 3-cinnolinyl, 6-cinnolinyl, 7-cinnolinyl, 3-methoxy-7-cinnolinyl, 2-pteridinyl, 6-pteridinyl, 7-pteridinyl, 6,7-dimethoxy-2-pteridinyl, 2-carbazolyl, 3-carbazolyl, 9-methyl-2-carbazolyl, 9-methyl-3-carbazolyl, β-carbolin-3-yl, 1-methyl-β-carbolin-3-yl, 1-methyl-β-carbolin-6-yl, 3-phenanthridinyl, 2-acridinyl, 3-acridinyl, 2-perimidinyl, 1-methyl-5-perimidinyl, 5-phenanthrolinyl, 6-phenanthrolinyl, 1-phenazinyl, 2-phenazinyl, 3-isothiazolyl, 4-isothiazolyl, 5-isothiazolyl, 2-phenothiazinyl, 3-phenothiazinyl, 10-methyl-3-phenothiazinyl, 3-isoxazolyl, 4-isoxazolyl, 5-isoxazolyl, 4-methyl-3-furazanyl, 2-phenoxazinyl or 10-methyl-2-phenoxazinyl.

Special preference is given to naphthyl, phenanthryl, anthryl, 5,6,7,8-tetrahydro-2-naphthyl, 5,6,7,8-tetrahydro-1-naphthyl, thienyl, benzo[b]thienyl, naphtho[2,3-b]thienyl, thianthrenyl, dibenzofuryl, chromenyl, xanthenyl, phenoxathiinyl, pyrrolyl, isoindolyl, indolyl, phenothiazinyl, biphenyl, terphenyl, fluorenyl or phenoxazinyl, each unsubstituted or substituted by $C_1$-$C_4$alkyl, $C_1$-$C_4$alkoxy, $C_1$-$C_4$alkylthio, hydroxy, phenylamino or by di($C_1$-$C_4$alkyl)amino, for example 1-naphthyl, 2-naphthyl, 1-phenylamino-4-naphthyl, 1-methylnaphthyl, 2-methylnaphthyl, 1-methoxy-2-naphthyl, 2-methoxy-1-naphthyl, 1-dimethylamino-2-naphthyl, 1,2-dimethyl-4-naphthyl, 1,2-dimethyl-6-naphthyl, 1,2-dimethyl-7-naphthyl, 1,3-dimethyl-6-naphthyl, 1,4-dimethyl-6-naphthyl, 1,5-dimethyl-2-naphthyl, 1,6-dimethyl-2-naphthyl, 1-hydroxy-2-naphthyl, 2-hydroxy-1-naphthyl, 1,4-dihydroxy-2-naphthyl, 7-phenanthryl, 1-anthryl, 2-anthryl, 9-anthryl, 3-benzo[b]thienyl, 5-benzo[b]thienyl, 2-benzo[b]thienyl, 4-dibenzofuryl, 4,7-dibenzofuryl, 4-methyl-7-dibenzofuryl, 2-xanthenyl, 8-methyl-2-xanthenyl, 3-xanthenyl, 2-pyrrolyl, 3-pyrrolyl, 2-phenothiazinyl, 3-phenothiazinyl, 10-methyl-3-phenothiazinyl.

Halogen is, for example, chlorine, bromine or iodine. Chlorine is preferred.

Alkanoyl having up to 25 carbon atoms is a branched or unbranched radical, for example formyl, acetyl, propionyl, butanoyl, pentanoyl, hexanoyl, heptanoyl, octanoyl, nonanoyl, decanoyl, undecanoyl, dodecanoyl, tridecanoyl, tetradecanoyl, pentadecanoyl, hexadecanoyl, heptadecanoyl, octadecanoyl, eicosanoyl or docosanoyl. Alkanoyl having from 2 to 18, especially from 2 to 12, e.g. from 2 to 6, carbon atoms is preferred. Acetyl is especially preferred.

$C_2$-$C_{25}$Alkanoyl substituted by a di($C_1$-$C_6$alkyl)phosphonate group is, for example,
$(CH_3CH_2O)_2POCH_2CO$-, $(CH_3O)_2POCH_2CO$-, $(CH_3CH_2CH_2CH_2O)_2POCH_2CO$-,
$(CH_3CH_2O)_2POCH_2CH_2CO$-, $(CH_3O)_2POCH_2CH_2CO$-, $(CH_3CH_2CH_2CH_2O)_2POCH_2CH_2CO$-,
$(CH_3CH_2O)_2PO(CH_2)_4CO$-, $(CH_3CH_2O)_2PO(CH_2)_8CO$- or $(CH_3CH_2O)_2PO(CH_2)_{17}CO$-.

Alkanoyloxy having up to 25 carbon atoms is a branched or unbranched radical, for example formyloxy, acetoxy, propionyloxy, butanoyloxy, pentanoyloxy, hexanoyloxy, heptanoyloxy, octanoyloxy, nonanoyloxy, decanoyloxy, undecanoyloxy, dodecanoyloxy, tridecanoyloxy, tetradecanoyloxy, pentadecanoyloxy, hexadecanoyloxy, heptadecanoyloxy, octadecanoyloxy, eicosanoyloxy or docosanoyloxy. Alkanoyloxy having from 2 to 18, especially from 2 to 12, e.g. from 2 to 6, carbon atoms is preferred. Acetoxy is especially preferred.

Alkenoyl having from 3 to 25 carbon atoms is a branched or unbranched radical, for example propenoyl, 2-butenoyl, 3-butenoyl, isobutenoyl, n-2,4-pentadienoyl, 3-methyl-2-butenoyl, n-2-octenoyl, n-2-dodecenoyl, isododecenoyl, oleoyl, n-2-octadecenoyl or n-4-octadecenoyl, Alkenoyl having from 3 to 18, especially from 3 to 12, e.g. from 3 to 6, more especially 3 or 4, carbon atoms is preferred.

$C_3$-$C_{25}$Alkenoyl interrupted by oxygen, sulfur or by $>N-R_{14}$ is, for example,
$CH_3OCH_2CH_2CH=CHCO$- or $CH_3OCH_2CH_2OCH=CHCO$-.

Alkenoyloxy having from 3 to 25 carbon atoms is a branched or unbranched radical, for example propenoyloxy, 2-butenoyloxy, 3-butenoyloxy, isobutenoyloxy, n-2,4-pentadienoyloxy, 3-methyl-2-butenoyloxy, n-2-octenoyloxy, n-2-dodecenoyloxy, isododecenoyloxy, oleoyloxy, n-2-octadecenoyloxy or n-4-octadecenoyloxy. Alkenoyloxy havng from 3 to 18, especially from 3 to 12, e.g. from 3 to 6, more especially 3 or 4, carbon atoms is preferred.

$C_3$-$C_{25}$Alkenoyloxy interrupted by oxygen, sulfur or by $>N-R_{14}$ is, for example,
$CH_3OCH_2CH_2CH=CHCOO$- or $CH_3OCH_2CH_2OCH=CHCOO$-.

$C_3$-$C_{25}$Alkanoyl interrupted by oxygen, sulfur or by $>N-R_{14}$ is, for example,
$CH_3$-O-$CH_2CO$-, $CH_3$-S-$CH_2CO$-, $CH_3$-NH-$CH_2CO$-, $CH_3$-N($CH_3$)-$CH_2CO$-,
$CH_3$-O-$CH_2CH_2$-O-$CH_2CO$-, $CH_3$-(O-$CH_2CH_2$-$)_2$O-$CH_2CO$-, $CH_3$-(O-$CH_2CH_2$-$)_3$O-$CH_2CO$- or $CH_3$-(O-$CH_2CH_2$-$)_4$O-$CH_2CO$-.

$C_3$-$C_{25}$Alkanoyloxy interrupted by oxygen, sulfur or by $>N-R_{14}$ is, for example,
$CH_3$-O-$CH_2COO$-, $CH_3$-S-$CH_2COO$-, $CH_3$-NH-$CH_2COO$-, $CH_3$-N($CH_3$)-$CH_2COO$-,
$CH_3$-O-$CH_2CH_2$-O-$CH_2COO$-, $CH_3$-(O-$CH_2CH_2$-$)_2$O-$CH_2COO$-,
$CH_3$-(O-$CH_2CH_2$-$)_3$O-$CH_2COO$- or $CH_3$-(O-$CH_2CH_2$-$)_4$O-$CH_2COO$-.

$C_6$-$C_9$Cycloalkylcarbonyl is, for example, cyclohexylcarbonyl, cycloheptylcarbonyl or cyclooctylcarbonyl. Cyclohexylcarbonyl is preferred.

$C_6$-$C_9$Cycloalkylcarbonyloxy is, for example, cyclohexylcarbonyloxy, cycloheptylcarbonyloxy or cyclooctylcarbonyloxy. Cyclohexylcarbonyloxy is preferred.

$C_1$-$C_{12}$Alkyl-substituted benzoyl, which preferably carries from 1 to 3, especially 1 or 2, alkyl groups, is, for example, o-, m- or p-methylbenzoyl, 2,3-dimethylbenzoyl, 2,4-dimethylbenzoyl, 2,5-dimethylbenzoyl, 2,6-dimethylbenzoyl, 3,4-dimethylbenzoyl, 3,5-dimethylbenzoyl, 2-methyl-6-ethylbenzoyl, 4-tert-butylbenzoyl, 2-ethylbenzoyl, 2,4,6-trimethylbenzoyl, 2,6-dimethyl-4-tert-butylbenzoyl or 3,5-di-tert-butylbenzoyl. Preferred substituents are $C_1$-$C_8$alkyl, especially $C_1$-$C_4$alkyl.

$C_1$-$C_{12}$Alkyl-substituted benzoyloxy, which preferably carries from 1 to 3, especially 1 or 2, alkyl groups, is, for example, o-, m- or p-methylbenzoyloxy, 2,3-dimethylbenzoyloxy, 2,4-dimethylbenzoyloxy, 2,5-dimethylbenzoyloxy, 2,6-dimethylbenzoyloxy, 3,4-dimethybenzoyloxy, 3,5-dimethylbenzoyloxy, 2-methyl-6-ethylbenzoyloxy, 4-tert-butylbenzoyloxy, 2-ethylbenzoyloxy, 2,4,6-trimethylbenzoyloxy, 2,6-dimethyl-4-tert-butybenzoyloxy or 3,5-di-tert-butylbenzoyloxy. Preferred substituents are $C_1$-$C_8$alkyl, especially $C_1$-$C_4$alkyl.

Alkyl having up to 25 carbon atoms is a branched or unbranched radical, for example methyl, ethyl, propyl, isopropyl, n-butyl, sec-butyl, isobutyl, tert-butyl, 2-ethylbutyl, n-pentyl, isopentyl, 1-methylpentyl, 1,3-dimethylbutyl, n-hexyl, 1-methylhexyl, n-heptyl, isoheptyl, 1,1,3,3-tetramethylbutyl, 1-methylheptyl, 3-methylheptyl, n-octyl, 2-ethylhexyl, 1,1,3-trimethylhexyl, 1,1,3,3-tetramethylpentyl, nonyl, decyl, undecyl, 1-methylundecyl, dodecyl, 1,1,3,3,5,5-hexamethylhexyl, tridecyl, tetradecyl, pentadecyl, hexadecyl, heptadecyl, octadecyl, eicosyl or docosyl. One of the preferred meanings of $R_2$ and $R_4$ is, for example, $C_1$-$C_{18}$alkyl. An especially preferred meaning of $R_4$ is $C_1$-$C_4$alkyl.

Alkenyl having from 3 to 25 carbon atoms is a branched or unbranched radical, for example propenyl, 2-butenyl, 3-butenyl, isobutenyl, n-2,4-pentadienyl, 3-methyl-2-butenyl, n-2-octenyl, n-2-dodecenyl, isododecenyl, oleyl, n-2-octadecenyl or n-4-octadecenyl. Alkenyl having from 3 to 18, especially from 3 to 12, e.g. from 3 to 6, more especially 3 or 4, carbon atoms is preferred.

Alkenyloxy having from 3 to 25 carbon atoms is a branched or unbranched radical, for example propenyloxy, 2-butenyloxy, 3-butenyloxy, isobutenyloxy, n-2,4-pentadienyloxy, 3-methyl-2-butenyloxy, n-2-octenyloxy, n-2-dodecenyloxy, isododecenyloxy, oleyloxy, n-2-octadecenyloxy or n-4-octadecenyloxy. Alkenyloxy having from 3 to 18, especially from 3 to 12, e.g. from 3 to 6, more especially 3 or 4, carbon atoms is preferred.

Alkynyl having from 3 to 25 carbon atoms is a branched or unbranched radical, for example propynyl ( $-CH_2-C\equiv CH$ ), 2-butynyl, 3-butynyl, n-2-octynyl or n-2-dodecynyl. Alkynyl having from 3 to 18, especially from 3 to 12, e.g. from 3 to 6, more especially 3 or 4, carbon atoms is preferred.

Alkynyloxy having from 3 to 25 carbon atoms is a branched or unbranched radical, for example propynyloxy ( $-OCH_2-C\equiv CH$ ), 2-butynyloxy, 3-butynyloxy, n-2-octynyloxy or n-2-dodecynyloxy. Alkynyloxy having from 3 to 18, especially from 3 to 12, e.g. from 3 to 6, moe especially 3 or 4, carbon atoms is preferred.

$C_2$-$C_{25}$Alkyl interrupted by oxygen, sulfur or by $\rangle N-R_{14}$ is, for example, $CH_3-O-CH_2-$, $CH_3-S-CH_2-$, $CH_3-NH-CH_2-$, $CH_3-N(CH_3)-CH_2-$, $CH_3-O-CH_2CH_2-O-CH_2-$, $CH_3-(O-CH_2CH_2-)_2O-CH_2-$, $CH_3-(O-CH_2CH_2-)_3O-CH_2-$ or $CH_3-(O-CH_2CH_2-)_4O-CH_2-$.

$C_7$-$C_9$Phenylalkyl is, for example, benzyl, α-methylbenzyl, α,α-dimethylbenzyl or 2-phenylethyl. Benzyl and α,α-dimethylbenzyl are preferred.

$C_7$-$C_9$Phenylalkyl that is unsubstituted or substituted on the phenyl radical by from 1 to 3 $C_1$-$C_4$alkyl groups is, for example, benzyl, α-methylbenzyl, α,α-dimethylbenzyl, 2-phenylethyl, 2-methylbenzyl, 3-methylbenzyl, 4-methylbenzyl, 2,4-dimethylbenzyl, 2,6-dimethybenzyl or 4-tert-butylbenzyl. Benzyl is preferred.

$C_7$-$C_{25}$Phenylalkyl unsubstituted or substituted on the phenyl radical by from 1 to 3 $C_1$-$C_4$alkyl groups and interrupted by oxygen, sulfur or by $\rangle N-R_{14}$ is a branched or unbranched radical, for example phenoxymethyl, 2-methylphenoxymethyl, 3-methyl-phenoxymethyl, 4-methyl-phenoxymethyl, 2,4-dimethyl-phenoxymethyl, 2,3-dimethyl-phenoxymethyl, phenylthiomethyl, N-methyl-N-phenyl-aminomethyl, N-ethyl-N-phenyl-aminomethyl, 4-tert-butylphenoxymethyl, 4-tert-butyl-phenoxyethoxy-methyl, 2,4-di-tert-butyl-phenoxymethyl, 2,4-di-tert-butyl-phenoxyethoxymethyl, phenoxyethoxyethoxyethoxymethyl, benzyloxymethyl, benzyloxyethoxymethyl, N-benzyl-N-ethyl-aminomethyl or N-benzyl-N-isopropyl-amino methyl.

$C_7$-$C_9$Phenylalkoxy is, for example, benzyloxy, α-methylbenzyloxy, α,α-dimethylbenzyloxy or 2-phenylethoxy. Benzyloxy is preferred.

$C_1$-$C_4$Alkyl-substituted phenyl, which contains preferably from 1 to 3, especially 1 or 2, alkyl groups, is, for example; o-, m- or p-methylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 2-methyl-6-ethylphenyl, 4-tert-butylphenyl, 2-ethylphenyl or 2,6-diethylphenyl.

$C_1$-$C_4$Alkyl-substituted phenoxy, which contains preferably from 1 to 3, especially 1 or 2, alkyl groups, is, for example, o-, m- or p-methylphenoxy, 2,3-dimethylphenoxy, 2,4-dimethylphenoxy, 2,5-dimethylphenoxy, 2,6-dimethylphenoxy, 3,4-dimethylphenoxy, 3,5-dimethylphenoxy, 2-methyl-6-ethylphenoxy, 4-tert-butylphenoxy, 2-ethylphenoxy or 2,6-diethylphenoxy.

Unsubstituted or $C_1$-$C_4$alkyl-substituted $C_5$-$C_8$cycloalkyl is, for example, cyclopentyl, methylcyclopentyl, dimethylcyclopentyl, cyclohexyl, methylcyclohexyl, dimethylcyclohexyl, trimethylcyclohexyl, tert-butylcyclohexyl, cycloheptyl or cyclooctyl. Cyclohexyl and tert-butylcyclohexyl are preferred.

Unsubstituted or $C_1$-$C_4$alkyl-substituted $C_5$-$C_8$cycloalkoxy is, for example, cyclopentyloxy, methylcyclopentyloxy, dimethylcyclopentyloxy, cyclohexyloxy, methylcyclohexyloxy, dimethylcyclohexyloxy, trimethylcyclohexyloxy, tert-butylcyclohexyloxy, cycloheptyloxy or cyclooctyloxy. Cyclohexyloxy and tert-butylcyclohexyloxy are preferred.

Alkoxy having up to 25 carbon atoms is a branched or unbranched radical, for example methoxy, ethoxy, propoxy, isopropoxy, n-butoxy, isobutoxy, pentyloxy, isopentyloxy, hexyloxy, heptyloxy, octyloxy, decyloxy, tetradecyloxy, hexadecyloxy or octadecyloxy. Alkoxy having from 1 to 12, especially from 1 to 8, e.g. from 1 to 6, carbon atoms is preferred.

$C_2$-$C_{25}$Alkoxy interrupted by oxygen, sulfur or by $\rangle$N-$R_{14}$ is, for example,
$CH_3$-O-$CH_2CH_2$O-, $CH_3$-S-$CH_2CH_2$O-, $CH_3$-NH-$CH_2CH_2$O-, $CH_3$-N($CH_3$)-$CH_2CH_2$O-,
$CH_3$-O-$CH_2CH_2$-O-$CH_2CH_2$O-, $CH_3$-(O-$CH_2CH_2$-$)_2$O-$CH_2CH_2$O-,
$CH_3$-(O-$CH_2CH_2$-$)_3$O-$CH_2CH_2$O- or $CH_3$-(O-$CH_2CH_2$-$)_4$O-$CH_2CH_2$O-.

Alkylthio having up to 25 carbon atoms is a branched or unbranched radical, for example methylthio, ethylthio, propylthio, isopropylthio, n-butylthio, isobutylthio, pentylthio, isopentylthio, hexylthio, heptylthio, octylthio, decylthio, tetradecylthio, hexadecylthio or octadecylthio. Alkylthio having from 1 to 12, especially from 1 to 8, e.g. from 1 to 6, carbon atoms is preferred.

Alkylamino having up to 4 carbon atoms is a branched or unbranched radical, for example methylamino, ethylamino, propylamino, isopropylamino, n-butylamino, isobutylamino or tert-butylamino.

Di($C_1$-$C_4$alkyl)amino means that the two radicals are each independently of the other branched or unbranched, for example dimethylamino, methylethylamino, diethylamino, methyl-n-propylamino, methylisopropylamino, methyl-n-butylamino, methylisobutylamino, ethylisopropylamino, ethyl-n-butylamino, ethylisobutylamino, ethyl-tert-butylamino, diethylamino, diisopropylamino, isopropyl-n-butylamino, isopropylisobutylamino, di-n-butylamino or diisobutylamino.

Alkanoylamino having up to 25 carbon atoms is a branched or unbranched radical, for example formylamino, acetylamino, propionylamino, butanoylamino, pentanoylamino, hexanoylamino, heptanoylamino, octanoylamino, nonanoylamino, decanoylamino, undecanoylamino, dodecanoylamino, tridecanoylamino, tetradecanoylamino, pentadecanoylamino, hexadecanoylamino, heptadecanoylamino, octadecanoylamino, eicosanoylamino or docosanoylamino. Alkanoylamino having from 2 to 18, especially from 2 to 12, e.g. from 2 to 6, carbon atoms is preferred.

$C_1$-$C_{18}$Alkylene is a branched or unbranched radical, for example methylene, ethylene, propylene, trimethylene, tetramethylene, pentamethylene, hexamethylene, heptamethylene, octamethylene, decamethylene, dodecamethylene or octadecamethylene. $C_1$-$C_{12}$Alkylene, especially $C_1$-$C_8$alkylene, is preferred.

An unsubstituted or $C_1$-$C_4$alkyl-substituted $C_5$-$C_{12}$cycloalkylene ring, which preferably contains from 1 to 3, especially 1 or 2, branched or unbranched alkyl groups, is, for example, cyclopentylene, methylcyclopentylene, dimethylcyclopentylene, cyclohexylene, methylcyclohexylene, dimethylcyclohexylene, trimethylcyclohexylene, tert-butylcyclohexylene, cycloheptylene, cyclooctylene or cyclodecylene. Cyclohexylene and tert-butylcyclohexylene are preferred.

$C_2$-$C_{18}$Alkylene interrupted by oxygen, sulfur or by $\rangle$N-$R_{14}$ is, for example, -$CH_2$-O-$CH_2$-,
-$CH_2$-S-$CH_2$-, -$CH_2$-NH-$CH_2$-, -$CH_2$-N($CH_3$)-$CH_2$-, -$CH_2$-O-$CH_2CH_2$-O-$CH_2$-,
-$CH_2$-(O-$CH_2CH_2$-$)_2$O-$CH_2$-, -$CH_2$-(O-$CH_2CH_2$-$)_3$O-$CH_2$-, -$CH_2$-(O-$CH_2CH_2$-$)_4$O-$CH_2$- or
-$CH_2CH_2$-S-$CH_2CH_2$-.

$C_2$-$C_{18}$Alkenylene is, for example, vinylene, methylvinylene, octenylethylene or dodecenylethylene. $C_2$-$C_8$Alkenylene is preferred.

Alkylidene having from 2 to 20 carbon atoms is, for example, ethylidene, propylidene, butylidene, pentylidene, 4-methylpentylidene, heptylidene, nonylidene, tridecylidene, nonadecylidene, 1-methylethylidene, 1-ethylpropylidene or 1-ethylpentylidene. $C_2$-$C_8$Alkylidene is preferred.

Phenylalkylidene having from 7 to 20 carbon atoms is, for example, benzylidene, 2-phenylethylidene or 1-phenyl-2-hexylidene. $C_7$-$C_9$Phenylalkylidene is preferred.

$C_5$-$C_8$Cycloalkylene is a saturated hydrocarbon group having two free valencies and at least one ring unit and is, for example, cyclopentylene, cyclohexylene, cycloheptylene or cyclooctylene. Cyclohexylene is preferred.

$C_7$-$C_8$Bicycloalkylene is, for example, bicycloheptylene or bicyclooctylene.

Unsubstituted or $C_1$-$C_4$alkyl-substituted phenylene or naphthylene is, for example, 1,2-, 1,3-, 1,4-phenylene, 1,2-, 1,3-, 1,4-, 1,6-, 1,7-, 2,6- or 2,7-naphthylene. 1,4-Phenylene is preferred.

An unsubstituted or $C_1$-$C_4$alkyl-substituted $C_5$-$C_8$cycloalkylidene ring, which contains preferably from 1 to 3, especially 1 or 2, branched or unbranched alkyl groups, is, for example, cyclopentylidene, methylcyclopentylidene, dimethylcyclopentylidene, cyclohexylidene, methylcyclohexylidene, dimethylcyclohexylidene, trimethylcyclohexylidene, tert-butylcyclohexylidene, cycloheptylidene or cyclooctylidene. Cyclohexylidene and tert-butylcyclohexylidene are preferred.

A mono-, di- or tri-valent metal cation is preferably an alkali metal, alkaline earth metal or aluminium cation, for example $Na^+$, $K^+$, $Mg^{++}$, $Ca^{++}$ or $Al^{+++}$.

Preferred benzofuran-2-ones are those of formula (I) wherein, when n is 1, $R_1$ is phenyl unsubstituted or substituted in the para-position by $C_1$-$C_{18}$alkylthio or by di($C_1$-$C_4$alkyl)amino; mono- to penta-substituted alkylphenyl having a sum total of a maximum of 18 carbon atoms in its 1 to 5 alkyl substituents; or naphthyl, biphenyl, terphenyl, phenanthryl, anthryl, fluorenyl, carbazolyl, thienyl, pyrrolyl, phenothiazinyl or 5,6,7,8-tetrahydronaphthyl, each unsubstituted or substituted by $C_1$-$C_4$alkyl, $C_1$-$C_4$alkoxy, $C_1$-$C_4$alkylthio, hydroxy or by amino.

Preference is also given to benzofuran-2-ones of formula I wherein, when n is 2,

$R_1$ is -$R_{12}$-X-$R_{13}$-,

$R_{12}$ and $R_{13}$ are phenylene,
X is oxygen or $-NR_{31}-$, and
$R_{31}$ is $C_1$-$C_4$alkyl.

A group of benzofuran-2-ones that is likewise preferred comprises those of formula I wherein, when n is 1,

$R_1$ is naphthyl, phenanthryl, thienyl, dibenzofuryl, carbazolyl or fluorenyl, each unsubstituted or substituted by $C_1$-$C_4$alkyl, $C_1$-$C_4$alkoxy, $C_1$-$C_4$alkylthio, hydroxy, halogen, amino, $C_1$-$C_4$-alkylamino or by di($C_1$-$C_4$alkyl)amino, or is a radical of formula II

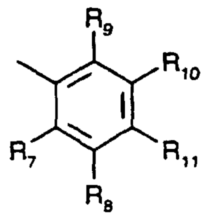 (II),

$R_7$, $R_8$, $R_9$, $R_{10}$ and $R_{11}$ are each independently of the others hydrogen, chlorine, bromine, hydroxy, $C_1$-$C_{18}$alkyl, $C_2$-$C_{18}$alkyl interrupted by oxygen or by sulfur; $C_1$-$C_{18}$alkoxy, $C_2$-$C_{18}$alkoxy interrupted by oxygen or by sulfur; $C_1$-$C_{18}$alkylthio, $C_3$-$C_{12}$alkenyloxy, $C_3$-$C_{12}$alkynyloxy, $C_7$-$C_9$phenylalkyl, $C_7$-$C_9$phenylalkoxy, unsubstituted or $C_1$-$C_4$alkyl-substituted phenyl; phenoxy, cyclohexyl, $C_5$-$C_8$cycloalkoxy, $C_1$-$C_4$alkylamino, di($C_1$-$C_4$alkyl)amino, $C_1$-$C_{12}$alkanoyl, $C_3$-$C_{12}$alkanoyl interrupted by oxygen or by sulfur; $C_1$-$C_{12}$alkanoyloxy, $C_3$-$C_{12}$alkanoyloxy interrupted by oxygen or by sulfur; $C_1$-$C_{12}$alkanoylamino, $C_3$-$C_{12}$alkenoyl, $C_3$-$C_{12}$alkenoyloxy, cyclohexylcarbonyl, cyclohexylcarbonyloxy, benzoyl or $C_1$-$C_4$alkyl-substituted benzoyl; benzoyloxy or $C_1$-$C_4$alkyl-substituted benzoyloxy;

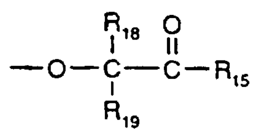

or

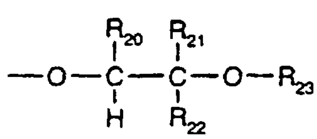 ,

or in formula II the radicals $R_7$ and $R_8$ or the radicals $R_8$ and $R_{11}$ together with the carbon atoms to which they are bonded form a benzo ring,
$R_{15}$ is hydroxy, $C_1$-$C_{12}$alkoxy or

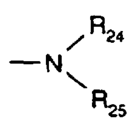 ,

$R_{18}$ and $R_{19}$ are each independently of the other hydrogen or $C_1$-$C_4$alkyl,
$R_{20}$ is hydrogen,
$R_{21}$ is hydrogen, phenyl, $C_1$-$C_{18}$alkyl, $C_2$-$C_{18}$alkyl interrupted by oxygen or by sulfur; $C_7$-$C_9$-phenylalkyl, or $C_7$-$C_{18}$phenylalkyl unsubstituted or substituted on the phenyl radical by from 1 to 3 $C_1$-$C_4$alkyl groups and inter-

rupted by oxygen or by sulfur, or the radicals $R_{20}$ and $R_{21}$ together with the carbon atoms to which they are bonded form a cyclohexylene ring that is unsubstituted or substituted by from 1 to 3 $C_1$-$C_4$alkyl groups,
$R_{22}$ is hydrogen or $C_1$-$C_4$alkyl,
$R_{23}$ is hydrogen, $C_1$-$C_{18}$alkanoyl, $C_3$-$C_{18}$alkenoyl, $C_3$-$C_{12}$alkanoyl interrupted by oxygen or by sulfur; $C_2$-$C_{12}$alkanoyl substituted by a di($C_1$-$C_6$alkyl)phosphonate group; $C_6$-$C_9$cycloalkylcarbonyl, benzoyl,

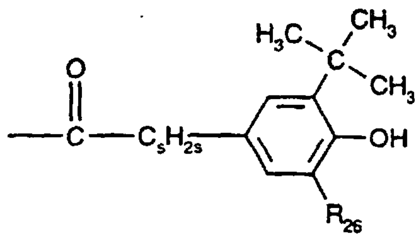 ,

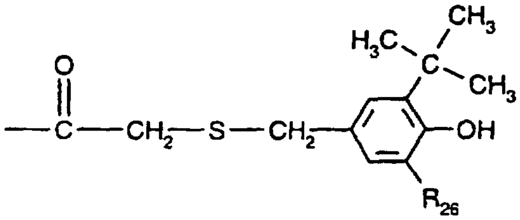 , 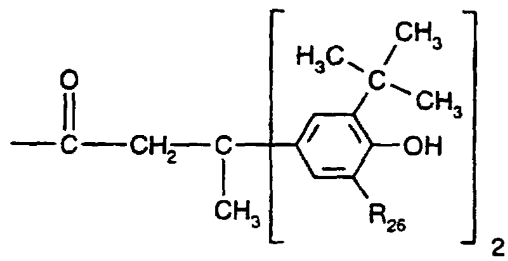 ,

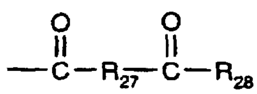 or 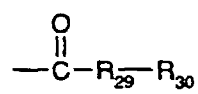 ,

$R_{24}$ and $R_{25}$ are each independently of the other hydrogen or $C_1$-$C_{12}$alkyl,
$R_{26}$ is hydrogen or $C_1$-$C_4$alkyl,
$R_{27}$ is $C_1$-$C_{12}$alkylene, $C_2$-$C_8$alkenylene, $C_2$-$C_8$alkylidene, $C_7$-$C_{12}$phenylalkylidene, $C_5$-$C_8$-cycloalkylene or phenylene,
$R_{28}$ is hydroxy, $C_1$-$C_{12}$alkoxy or

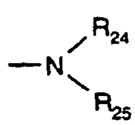 ,

$R_{29}$ is oxygen or -NH-,
$R_{30}$ is $C_1$-$C_{18}$alkyl or phenyl, and
s is 1 or 2.

Preference is also given to benzofuran-2-ones of formula I wherein, when n is 1,

$R_1$ is phenanthryl, thienyl, dibenzofuryl, unsubstituted or $C_1$-$C_4$alkyl-substituted carbazolyl; or fluorenyl; or $R_1$ is a radical of formula II

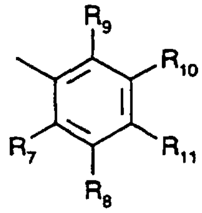 (II),

$R_7$, $R_8$, $R_9$, $R_{10}$ and $R_{11}$ are each independently of the others hydrogen, chlorine, hydroxy, $C_1$-$C_{18}$alkyl, $C_1$-$C_{18}$alkoxy, $C_1$-$C_{18}$alkylthio, $C_3$-$C_4$alkenyloxy, $C_3$-$C_4$alkynyloxy, phenyl, benzoyl, benzoyloxy or

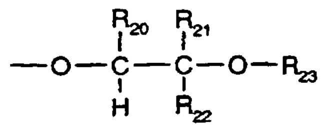 ,

$R_{20}$ is hydrogen,
$R_{21}$ is hydrogen, phenyl or $C_1$-$C_{18}$alkyl, or the radicals $R_{20}$ and $R_{21}$ together with the carbon atoms to which they are bonded form a cyclohexylene ring that is unsubstituted or substituted by from 1 to 3 $C_1$-$C_4$alkyl groups,
$R_{22}$ is hydrogen or $C_1$-$C_4$alkyl, and
$R_{23}$ is hydrogen, $C_1$-$C_{12}$alkanoyl or benzoyl.

Special preference is given to benzofuran-2-ones of formula I wherein, when n is 1,

$R_7$, $R_8$, $R_9$, $R_{10}$ and $R_{11}$ are each independently of the others hydrogen, $C_1$-$C_{12}$alkyl, $C_1$-$C_4$alkylthio or phenyl.

Of special interest are benzofuran-2-ones of formula I wherein

$R_2$, $R_3$, $R_4$ and $R_5$ are each independently of the others hydrogen, chlorine, $C_1$-$C_{18}$alkyl, benzyl, phenyl, $C_5$-$C_8$cycloalkyl, $C_1$-$C_{18}$alkoxy, $C_1$-$C_{18}$alkylthio, $C_1$-$C_{18}$alkanoyloxy, $C_1$-$C_{18}$-alkanoylamino, $C_3$-$C_{18}$alkenoyloxy or benzoyloxy; or the radicals $R_2$ and $R_3$ or the radicals $R_3$ and $R_4$ or the radicals $R_4$ and $R_5$ together with the carbon atoms to which they are bonded form a benzo ring, or $R_4$ may additionally be $-(CH_2)_p-COR_{15}$ or $-(CH_2)_qOH$, or when $R_3$, $R_5$ and $R_6$ are hydrogen, $R_4$ may additionally be a radical of formula III,
$R_{15}$ is hydroxy, $C_1$-$C_{12}$alkoxy or

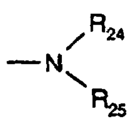 ,

$R_{16}$ and $R_{17}$ are methyl groups or together with the carbon atom to which they are bonded form a $C_5$-$C_8$cycloalkylidene ring that is unsubstituted or substituted by from 1 to 3 $C_1$-$C_4$alkyl groups,
$R_{24}$ and $R_{25}$ are each independently of the other hydrogen or $C_1$-$C_{12}$alkyl,
p is 1 or 2, and
q is 2, 3, 4, 5 or 6.

Also of special interest are benzofuran-2-ones of formula I wherein at least two of the radicals $R_2$, $R_3$, $R_4$ and $R_5$ are hydrogen.
Especially interesting compositions are those comprising as component (c) (i) at least one compound of formula I wherein $R_3$ and $R_5$ are hydrogen.
Very special preference is given to benzofuran-2-ones of formula I wherein

$R_2$ is $C_1$-$C_4$alkyl,
$R_3$ is hydrogen,

$R_4$ is $C_1$-$C_4$alkyl or, when $R_6$ is hydrogen, $R_4$ may additionally be a radical of formula III,
$R_5$ is hydrogen, and
$R_{16}$ and $R_{17}$ together with the carbon atom to which they are bonded form a cyclohexylidene ring.

The following compounds are examples of the benzofuran-2-one type that are especially suitable as component (b) in the composition according to the invention: 3-[4-(2-acetoxyethoxy)phenyl]-5,7-di-tert-butyl-benzofuran-2-one; 5,7-di-tert-butyl-3-[4-(2-stearoyloxyethoxy)phenyl]-benzofuran-2-one; 3,3'-bis[5,7-di-tert-butyl-3-(4-[2-hydroxyethoxy]phenyl)-benzofuran-2-one]; 5,7-di-tert-butyl-3-(4-ethoxyphenyl)benzofuran-2-one; 3-(4-acetoxy-3,5-dimethylphenyl)-5,7-di-tert-butyl-benzofuran-2-one; 3-(3,5-dimethyl-4-pivaloyloxy-phenyl)-5,7-di-tert-butyl-benzofuran-2-one; 5,7-di-tert-butyl-3-phenyl-benzofuran-2-one; 5,7-di-tert-butyl-3-(3,4-dimethylphenyl)-benzofuran-2-one; 5,7-di-tert-butyl-3-(2,3-dimethylphenyl)-benzofuran-2-one.

Very special preference is given to benzofuran-2-ones of formula V

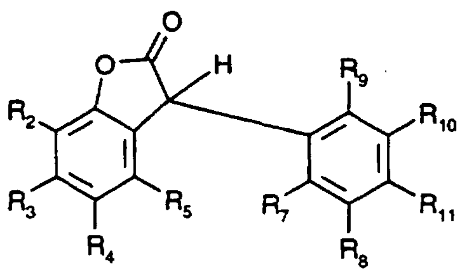

(V)

wherein

$R_2$ is hydrogen or $C_1$-$C_6$alkyl,
$R_3$ is hydrogen,
$R_4$ is hydrogen or $C_1$-$C_6$alkyl,
$R_5$ is hydrogen,
$R_7$, $R_8$, $R_9$, $R_{10}$ and $R_{11}$ are each independently of the others hydrogen, $C_1$-$C_4$alkyl, $C_1$-$C_4$-alkoxy or

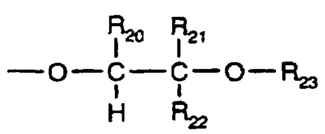

with the proviso that at least two of the radicals $R_7$, $R_8$,
$R_9$, $R_{10}$ and $R_{11}$ are hydrogen,
$R_{20}$, $R_{21}$ and $R_{22}$ are hydrogen, and
$R_{23}$ is $C_2$-$C_4$alkanoyl.

Special preference is given to benzofuran-2-ones of formula Va or Vb

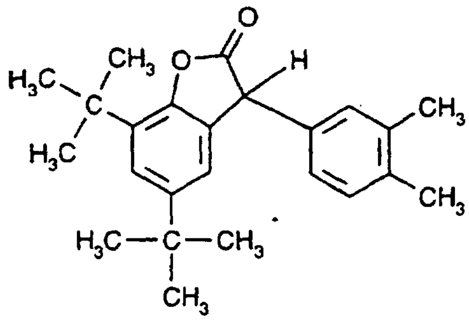
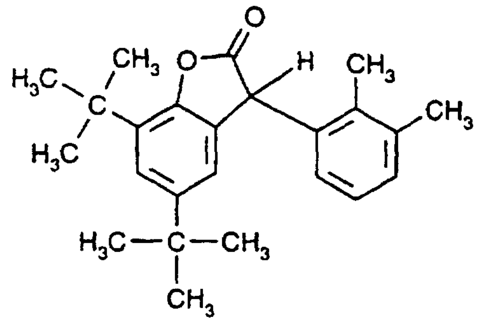

(Va) (Vb)

or a mixture of the two compounds of formulae Va and Vb.

The compounds of the benzofuran-2-one type as component (b) are known in the literature and the preparation thereof is described, for example, in US 5 516 920.

Component (b) is added preferably in an amount of from 0.0001 to 10% by weight, especially from 0.001 to 7% by weight and more especially from 0.002 to 5% by weight, based on the monomer, oligomer, co-oligomer, polymer or copolymer.

If a mixture of a stable sterically hindered nitroxyl free-radical and a compound of the benzofuran-2-one type is used, the ratio by weight is preferably from 1:10 to 10:1.

The invention relates also to a method of increasing the storage stablity and preventing premature polymerisation or crosslinking of

a1) at least one oligomer, co-oligomer, polymer or copolymer or a mixture thereof having at least one ethylenically unsaturated bond; or

a2) a mixture of at least one ethylenically unsaturated monomer with at least one oligomer, co-oligomer, polymer or copolymer having at least one ethylenically unsaturated bond, which method comprises adding at least one stable sterically hindered nitroxyl free-radical or at least one compound of the benzofuran-2-one type or a mixture of the two compounds.

The present invention relates also to the use of a stable sterically hindered nitroxyl free-radical or a compound of the benzofuran-2-one type or a mixture of the two compounds for increasing the storage stability and preventing premature polymerisation or crosslinking of

a1) at least one oligomer, co-oligomer, polymer or copolymer or a mixture thereof having at least one ethylenically unsaturated bond; or

a2) a mixture of at least one ethylenically unsaturated monomer with at least one oligomer, co-oligomer, polymer or copolymer having at least one ethylenically unsaturated bond.

The definitions and preferred meanings mentioned above apply also to the claimed method and to the use of the stabilisers.

The following Examples illustrate the invention.

Example 1

Table 1:

| Composition of the coating | |
|---|---|
| 51 parts | aliphatic urethane diacrylate Ebecryl® 4858 (UCB Chemicals) unstabilised |
| 10 parts | tripropylene glycol diacrylate (UCB Chemicals) unstabilised |

Table 1: (continued)

| Composition of the coating | |
|---|---|
| 13 parts | trimethylolpropane triacrylate (UCB Chemicals) unstabilised |
| 0.5 part | Byk® 300 flow-control agent (Byk-Chemie) |
| 0.22 part | Irgacure® 819 bisacylphosphine oxide (Ciba Spezialitäten Chemie AG) |
| 2 parts | Irgacure 184® α-hydroxyketone (Ciba Spezialitäten Chemie AG) |

The stabilisers indicated in Tables 2 and 3 and optionally light stabilisers are incorporated into the composition described above. The formulations are applied with a doctor blade to a white coil-coated aluminium sheet so that a dry film thickness of 45 µm is obtained. The coating film is cured using 2X120 W/cm medium-pressure mercury vapour lamps at 5 m/min. The sheet is divided into three parts.

One part is left without after-treatment, while the second part is again irradiated with 2X120 W/cm. The third part is stored in a circulating-air oven for 30 min at 130°C.

The samples are then left at room temperature for 15 min and 4 h after the curing and the after-treatment, and the yellowing b* according to DIN 6174 of each sample is measured. A higher b* value indicates a higher degree of yellowing. The results are shown in Tables 2 and 3.

Table 2:

| b* value according to DIN 6174 | | | | | |
|---|---|---|---|---|---|
| Treatment | without additive | 0.02% toluquinone | 0.02% Comp. 101 | 0.02% Comp. 201 | 0.02% Comp. 102 |
| 1 X 5 m/min | | | | | |
| 15 min | 4.2 | 4.5 | 4.4 | 4.4 | 4.1 |
| 4 h | 3.4 | 3.8 | 3.7 | 3.7 | 3.5 |
| 2X5 m/min | | | | | |
| 15 min | 4.7 | 4.9 | 4.6 | 4.8 | 4.7 |
| 4 h | 4.0 | 4.2 | 4.0 | 4.1 | 4.0 |
| 30 min 130°C | | | | | |
| 15 min | 1.0 | 1.3 | 0.9 | 1.1 | 1.1 |
| 4 h | 1.1 | 1.3 | 0.9 | 1.2 | 1.2 |

Table 3:

| b* value according to DIN 6174 | | | | | |
|---|---|---|---|---|---|
| Treatment | without additive | 0.02% toluquinone | 0.02% Comp. 101 | 0.02% Comp. 201 | 0.02% Comp. 102 |
| 1 X 5 m/min | | | | | |
| 15 min | 3.4 | 3.5 | 3.2 | 3.4 | 3.3 |
| 4 h | 2.9 | 3.1 | 2.9 | 3.0 | 2.9 |
| 2X5 m/min | | | | | |
| 15 min | 4.2 | 4.4 | 4.1 | 4.3 | 4.2 |
| 4 h | 3.7 | 3.9 | 3.7 | 3.8 | 3.7 |
| 30 min 130°C | | | | | |
| 15 min | 2.4 | 2.6 | 2.2 | 2.3 | 2.5 |

Table 3: (continued)

| b* value according to DIN 6174 | | | | | |
|---|---|---|---|---|---|
| Treatment | without additive | 0.02% toluquinone | 0.02% Comp. 101 | 0.02% Comp. 201 | 0.02% Comp. 102 |
| 30 min 130°C | | | | | |
| 4 h | 2.5 | 2.7 | 2.3 | 2.4 | 2.6 |

All formulations in Table 3 contain additional light stabilisers: 1.5% Tinuvin® 400 + 1.0% Tinuvin® 292 (% by weight, based on monomer and oligomer).

The storage stability of the stabilised samples in Tables 2 and 3 is more than 3 months at 60°C.

Example 2

Table 4:

| Composition of the coating | |
|---|---|
| 51 parts | aliphatic urethane hexaacrylate Ebecryl® 1290 (UCB Chemicals) unstabilised |
| 30 parts | isopropanol (Fluka Chemicals) |
| 13 parts | trimethylolpropane triacrylate (UCB Chemicals) unstabilised |
| 0.19 part | Irgacure® 819 bisacylphosphine oxide (Ciba Spezialitäten Chemie AG) |
| 1.73 parts | Irgacure® 184 α-hydroxyketone (Ciba Spezialitäten Chemie AG) |

The samples are prepared and treated and their yellowing measured as described in Example 1. The results are shown in Tables 5 and 6.

Table 5:

| b* value according to DIN 6174 | | | | | |
|---|---|---|---|---|---|
| | without additive | 0.02% toluquinone | 0.02% Comp. 101 | 0.02% Comp. 102 | 0.01% MEHQ + 0.1% Comp. 101 |
| 1 X 5 m/min | | | | | |
| 15 min | 6.3 | 6.6 | 6.3 | 6.3 | 6.2 |
| 4 h | 5.6 | 6 | 5.6 | 5.6 | 5.5 |
| 2X5 m/min | | | | | |
| 15 min | 7.4 | 7.8 | 7.4 | 7.2 | 7.3 |
| 4 h | 6.6 | 7 | 6.6 | 6.4 | 6.5 |
| 30 min 130°C | | | | | |
| 15 min | 4 | 4.6 | 4 | 4.3 | 3.9 |
| 4 h | 3.7 | 3.9 | 3.4 | 3.7 | 3.2 |
| MEHQ = hydroquinone monomethyl ether = 4-methoxyphenol | | | | | |

Table 6:

| b* value according to DIN 6174 | | | | | |
|---|---|---|---|---|---|
| | without additive | 0.02% toluquinone | 0.02% Comp. 101 | 0.02% Comp. 102 | 0.01% MEHQ + 0.1% Comp. 101 |
| 1 X 5 m/min | | | | | |
| 15 min | 6 | 6.3 | 6.1 | 6.2 | 6.2 |
| 4 h | 5 | 5.3 | 5 | 5.1 | 5.1 |
| 2X5 m/min | | | | | |
| 15 min | 7.5 | 7.9 | 7.6 | 7.7 | 7.6 |
| 4 h | 6.6 | 6.8 | 6.6 | 6.8 | 6.6 |
| 30 min 130°C | | | | | |
| 15 min | 3.5 | 3.7 | 3.3 | 3.5 | 3.4 |
| 4 h | 3.5 | 3.6 | 3.3 | 3.4 | 3.4 |
| MEHQ = hydroquinone monomethyl ether = 4-methoxyphenol | | | | | |

All formulations in Table 6 contain additional light stabilisers: 1.5% Tinuvin® 400 + 1.0% Tinuvin® 292 (% by weight, based on monomer and oligomer).

The storage stability of the stabilised samples in Tables 5 and 6 is more than 3 months at 60°C.

Irgacure® 819 and Irgacure® 184 are photoinitiators of Ciba Spezialitätenchemie;
Tinuvin® 400 and Tinuvin® 292 are light stabilisers of Ciba Spezialitätenchemie;
Comp. 201 is a mixture of

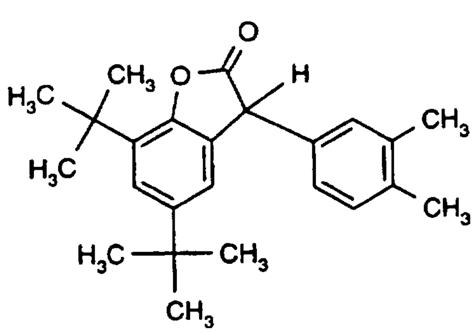

and

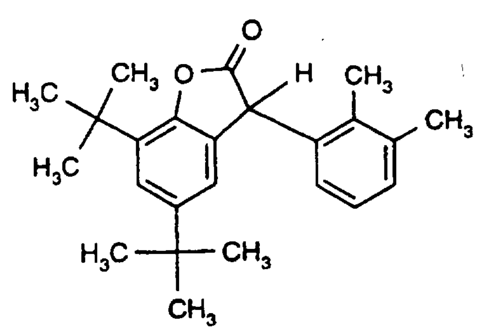

.

Comp.: 101 =

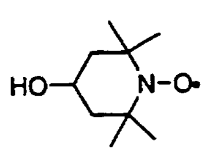

Comp.: 102 = bis(1-oxy-2,2,6,6-tetramethylpiperidin-4-yl) sebacate (Prostab ®5415, Ciba Spezialitäten Chemie)

## Claims

1. Use of a stable sterically hindered nitroxyl free-radical or a compound of the benzofuran-2-one type or a mixture of the two compounds for increasing the storage stability of an UV-curable composition and preventing yellowing under the action of UV-light, said composition comprising

   a1) at least one oligomer, co-oligomer, polymer or copolymer or a mixture thereof having at least one ethylenically unsaturated bond; or
   a2) a mixture of at least one ethylenically unsaturated monomer with at least one oligomer, co-oligomer, polymer or copolymer having at least one ethylenically unsaturated bond.

2. Use according to claim 1, wherein the monomer, oligomer, co-oligomer, polymer or copolymer has at least 2 ethylenically unsaturated bonds.

3. Use according to claim 1, wherein the monomer, oligomer, co-oligomer, polymer or copolymer contains at least one acrylate or methacrylate functionality or is a polyester derived from an unsaturated acid.

4. Use according to claim 1, Wherein the stable sterically hindered nitroxyl free-radicals have the following structural feature,

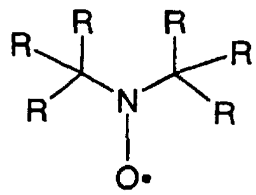

or

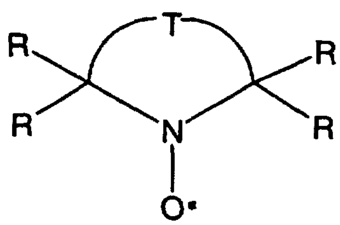

   wherein R is alkyl and T is a group required to complete a 5- or 6-membered ring.

5. Use according to claim 1, wherein the stable sterically hindered nitroxyl free-radicals are selected from the group consisting of
   bis(1-oxy-2,2,6,6-tetramethylpiperidin-4-yl) sebacate, 4-hydroxy-1-oxy-2,2,6,6-tetramethylpiperidine, 4-ethoxy-1-oxy-2,2,6,6-tetramethylpiperidine, 4-propoxy-1-oxy-2,2,6,6-tetramethylpiperidine, 4-acetamido-1-oxy-2,2,6,6-tetramethylpiperidine, 1-oxy-2,2,6,6-tetramethylpiperidine, 1-oxy-2,2,6,6-tetramethylpiperidin-4-one, 1-oxy-2,2,6,6-tetramethylpiperidin-4-yl acetate, 1-oxy-2,2,6,6-tetramethyipiperidin-4-yl 2-ethylhexanoate, 1-oxy-2,2,6,6-tetramethylpiperidin-4-yl stearate, 1-oxy-2,2,6,6-tetramethylpiperidin-4-yl benzoate, 1-oxy-2,2,6,6-tetramethylpiperidin-4-yl 4-tert-butyl-benzoate, bis(1-oxy-2,2,6,6-tetramethylpiperidin-4-yl) succinate, bis(1-oxy-2,2,6,6-tetramethylpiperidin-4-yl) adipate, bis(1-oxy-2,2,6,6-tetramethylpiperidin-4-yl) n-butylmalonate, bis(1-oxy-2,2,6,6-tetramethylpiperidin-4-yl) phthalate, bis(1-oxy-2,2,6,6-tetramethylpiperidin-4-yl) isophthalate, bis(1-oxy-2,2,6,6-tetramethylpiperidin-4-yl) terephthalate, bis(1-oxy-2,2,6,6-tetramethylpiperidin-4-yl) hexahydroterephthalate, N,N'-bis(1-oxy-2,2,6,8-tetramethylpiperidin-4-yl)adipamide, N-(1-oxy-2,2,6,6-tetramethylpiperidin-4-yl) caprolactam, N-(1-oxy-2,2,6,6-tetramethylpiperidin-4-yl)-dodecylsuccinimide, 2,4,6-tris[N-butyl-N-(1-oxy-2,2,6,6-tetramethylpiperidin-4-yl)]-s-triazine, 4,4'-ethylenebis(1-oxy-2,2,6,6-tetramethylpiperazin-3-one), 2-oxy-1,1,3,3-tetramethyl-2-isobenzazole, 1-oxy-2,2,5,5-tetramethylpyrrolidine and N,N-bis(1,1,3,3-tetramethylbutyl)-nitroxide.

6. Use according to claim 1, comprising as component of the benzofuran-2-one type a compound of formula I

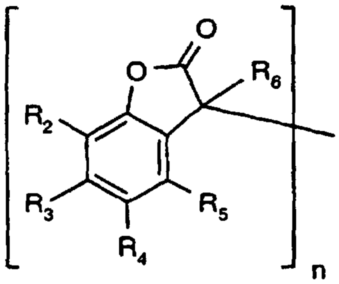

(I)

wherein, when n is 1,

$R_1$ is naphthyl, phenanthryl, anthryl, 5,6,7,8-tetrahydro-2-naphthyl, 5,6,7,8-tetrahydro-1-naphthyl, thienyl, benzo[b]thienyl, naphtho[2,3-b]thienyl, thianthrenyl, dibenzofuryl, chromenyl, xanthenyl, phenoxathiinyl, pyrrolyl, imidazolyl, pyrazolyl, pyrazinyl, pyrimidinyl, pyridazinyl, indolizinyl, isoindolyl, indolyl, indazolyl, purinyl, quinolizinyl, isoquinolyl, quinolyl, phthalazinyl, naphthyridinyl, quinoxalinyl, quinazolinyl, cinnolinyl, pteridinyl, carbazolyl, β-carbolinyl, phenanthridinyl, acridinyl, perimidinyl, phenanthrolinyl, phenazinyl, isothiazolyl, phenothiazinyl, isoxazolyl, furazanyl, biphenyl, terphenyl, fluorenyl or phenoxazinyl, each unsubstituted or substituted by $C_1$-$C_4$alkyl, $C_1$-$C_4$alkoxy, $C_1$-$C_4$alkylthio, hydroxy, halogen, amino, $C_1$-$C_4$alkylamino, phenylamino or by di($C_1$-$C_4$alkyl)amino, or $R_1$ is a radical of formula II

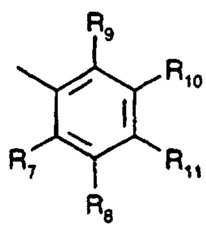

(II)

and

when n is 2,

$R_1$ is phenylene or naphthylene, each unsubstituted or substituted by $C_1$-$C_4$alkyl or by hydroxy; or is $-R_{12}-X-R_{13}-$,

$R_2$, $R_3$, $R_4$ and $R_5$ are each independently of the others hydrogen, chlorine, hydroxy, $C_1$-$C_{25}$alkyl, $C_7$-$C_9$phenylalkyl, unsubstituted or $C_1$-$C_4$alkyl-substituted phenyl; unsubstituted or $C_1$-$C_4$alkyl-substituted $C_5$-$C_8$cycloalkyl; $C_1$-$C_{18}$alkoxy, $C_1$-$C_{18}$alkylthio, $C_1$-$C_4$alkylamino, di($C_1$-$C_4$alkyl)amino, $C_1$-$C_{25}$alkanoyloxy, $C_1$-$C_{25}$alkanoylamino, $C_3$-$C_{25}$alkenoyloxy,

$C_3$-$C_{25}$alkanoyloxy interrupted by oxygen, sulfur or by $>N-R_{14}$ ; $C_6$-$C_9$cycloalkylcarbonyloxy, benzoyloxy or $C_1$-$C_{12}$alkyl-substituted benzoyloxy; or the radicals $R_2$ and $R_3$ or the radicals $R_3$ and $R_4$ or the radicals $R_4$ and $R_5$ together with the carbon atoms to which they are bonded form a benzo ring, or $R_4$ may additionally be $-(CH_2)_p-COR_{15}$ or $-(CH_2)_qOH$, or when $R_3$, $R_5$ and $R_6$ are hydrogen, $R_4$ may additionally be a radical of formula III

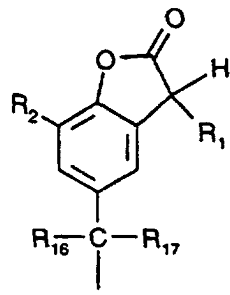

(III)

wherein $R_1$ is as defined above for n = 1,
$R_6$ is hydrogen or a radical of formula IV

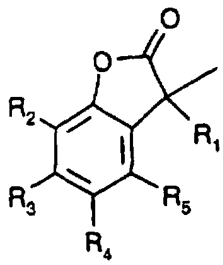

(IV),

wherein $R_4$ is not a radical of formula III and $R_1$ is as defined above for n = 1,
$R_7$, $R_8$, $R_9$, $R_{10}$ and $R_{11}$ are each independently of the others hydrogen, halogen, hydroxy, $C_1$-$C_{25}$alkyl, $C_2$-$C_{25}$alkyl interrupted by oxygen, sulfur or by $>N-R_{14}$ ; $C_1$-$C_{25}$alkoxy,
$C_2$-$C_{25}$alkoxy interrupted by oxygen, sulfur or by $>N-R_{14}$ ; $C_1$-$C_{25}$alkylthio, $C_3$-$C_{25}$alkenyl,
$C_3$-$C_{25}$alkenyloxy, $C_3$-$C_{25}$alkynyl, $C_3$-$C_{25}$alkynyloxy, $C_7$-$C_9$phenylalkyl, $C_7$-$C_9$phenylalkoxy, unsubstituted or $C_1$-$C_4$alkyl-substituted phenyl; unsubstituted or $C_1$-$C_4$alkyl-substituted phenoxy; unsubstituted or $C_1$-$C_4$alkyl-substituted $C_5$-$C_8$cycloalkyl; unsubstituted or $C_1$-$C_4$alkyl-substituted $C_5$-$C_8$cycloalkoxy; $C_1$-$C_4$alkylamino, di($C_1$-$C_4$alkyl)amino,
$C_1$-$C_{25}$alkanoyl, $C_3$-$C_{25}$alkanoyl interrupted by oxygen, sulfur or by $>N-R_{14}$ ;
$C_1$-$C_{25}$alkanoyloxy, $C_3$-$C_{25}$alkanoyloxy interrupted by oxygen, sulfur or by $>N-R_{14}$ ;
$C_1$-$C_{25}$alkanoylamino, $C_3$-$C_{25}$alkenoyl, $C_3$-$C_{25}$alkenoyl interrupted by oxygen, sulfur or by $>N-R_{14}$ ; $C_3$-$C_{25}$alkenoyloxy, $C_3$-$C_{25}$alkenoyloxy interrupted by oxygen, sulfur or by $>N-R_{14}$ ; $C_6$-$C_9$cycloalkylcarbonyl, $C_6$-$C_9$cycloalkylcarbonyloxy, benzoyl or $C_1$-$C_{12}$alkyl-substituted benzoyl; benzoyloxy or $C_1$-$C_{12}$alkyl-substituted benzoyloxy;

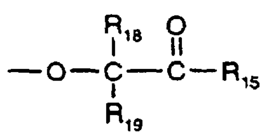 or 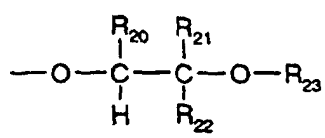 ,

or in formula II the radicals $R_7$ and $R_8$ or the radicals $R_8$ and $R_{11}$ together with the carbon atoms to which they are bonded form a benzo ring,
$R_{12}$ and $R_{13}$ are each independently of the other unsubstituted or $C_1$-$C_4$alkyl-substituted phenylene or naphthylene,
$R_{14}$ is hydrogen or $C_1$-$C_8$alkyl,
$R_{15}$ is hydroxy,

$$\left[-O^{-}\ \frac{1}{r}M^{r+}\right] ,$$

$C_1$-$C_{18}$alkoxy or

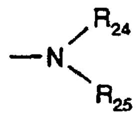,

$R_{16}$ and $R_{17}$ are each independently of the other hydrogen, $CF_3$, $C_1$-$C_{12}$alkyl or phenyl, or $R_{16}$ and $R_{17}$ together with the carbon atom to which they are bonded form a $C_5$-$C_8$cycloalkylidene ring that is unsubstituted or substituted by from 1 to 3 $C_1$-$C_4$alkyl groups;
$R_{18}$ and $R_{19}$ are each independently of the other hydrogen, $C_1$-$C_4$alkyl or phenyl,
$R_{20}$ is hydrogen or $C_1$-$C_4$alkyl,
$R_{21}$ is hydrogen, unsubstituted or $C_1$-$C_4$alkyl-substituted phenyl; $C_1$-$C_{25}$alkyl, $C_2$-$C_{25}$alkyl interrupted by oxygen, sulfur or by $>N-R_{14}$ ; $C_7$-$C_9$phenylalkyl that is unsubstituted or substituted on the phenyl radical by from 1 to 3 $C_1$-$C_4$alkyl groups; $C_7$-$C_{25}$phenylalkyl that is unsubstituted or substituted on the phenyl radical by from 1 to 3 $C_1$-$C_4$alkyl groups and interrupted by oxygen, sulfur or by $>N-R_{14}$ , or the radicals $R_{20}$ and $R_{21}$ together with the carbon atoms to which they are bonded form a $C_5$-$C_{12}$cycloalkylene ring that is unsubstituted or substituted by from 1 to 3 $C_1$-$C_4$alkyl groups;
$R_{22}$ is hydrogen or $C_1$-$C_4$alkyl,
$R_{23}$ is hydrogen, $C_1$-$C_{25}$alkanoyl, $C_3$-$C_{25}$alkenoyl, $C_3$-$C_{25}$alkanoyl interrupted by oxygen, sulfur or by $>N-R_{14}$ ; $C_2$-$C_{25}$alkanoyl substituted by a di($C_1$-$C_6$alkyl)phosphonate group; $C_6$-$C_9$cycloalkylcarbonyl, thenoyl, furoyl, benzoyl or $C_1$-$C_{12}$alkyl-substituted benzoyl;

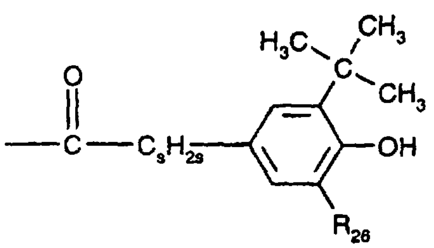, 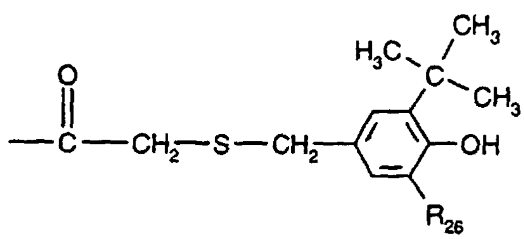,

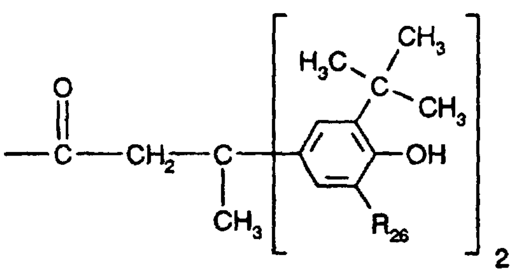, 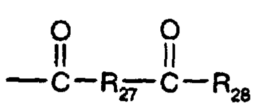 or 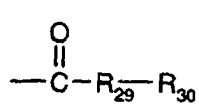,

$R_{24}$ and $R_{25}$ are each independently of the other hydrogen or $C_1$-$C_{18}$alkyl,
$R_{26}$ is hydrogen or $C_1$-$C_8$alkyl,
$R_{27}$ is a direct bond, $C_1$-$C_{18}$alkylene, $C_2$-$C_{18}$alkylene interrupted by oxygen, sulfur or by $>N-R_{14}$ ; $C_2$-$C_{18}$alkenylene, $C_2$-$C_{20}$alkylidene, $C_7$-$C_{20}$phenylalkylidene, $C_5$-$C_8$cycloalkylene, $C_7$-$C_8$bicycloalkylene, unsubstituted or $C_1$-$C_4$alkyl-substituted phenylene,

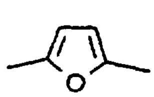 or 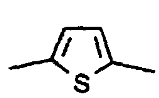,

$R_{28}$ is hydroxy,

$$\left[-O^{-}\ \frac{1}{r}M^{r+}\right],$$

$C_1$-$C_{18}$alkoxy or

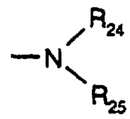

,

$R_{29}$ is oxygen, -NH- or

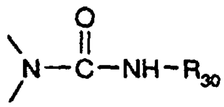

,

$R_{30}$ is $C_1$-$C_{18}$alkyl or phenyl,
$R_{31}$ is hydrogen or $C_1$-$C_{18}$alkyl,
M is an r-valent metal cation,
X is a direct bond, oxygen, sulfur or -$NR_{31}$-,
n is 1 or 2,
p is 0, 1 or 2,
q is 1, 2, 3, 4, 5 or 6,
r is 1, 2 or 3, and
s is 0, 1 or 2.

**7.** Use according to claim 6, comprising as component of the benzofuran-2-one type a compound of formula V

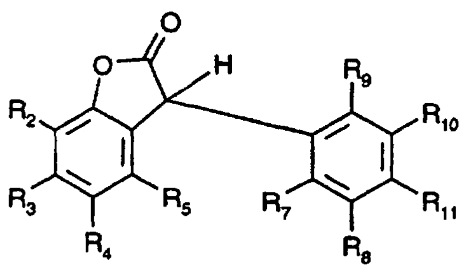

(V),

wherein

$R_2$ is hydrogen or $C_1$-$C_6$alkyl,
$R_3$ is hydrogen,
$R_4$ is hydrogen or $C_1$-$C_6$alkyl,
$R_5$ is hydrogen,
$R_7$, $R_8$, $R_9$, $R_{10}$ and $R_{11}$ are each independently of the others hydrogen, $C_1$-$C_4$alkyl, $C_1$-$C_4$-alkoxy or

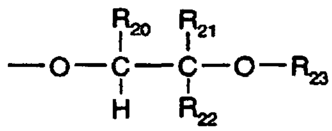

with the proviso that at least two of the radicals $R_7$, $R_8$, $R_9$, $R_{10}$ and $R_{11}$ are hydrogen, $R_{20}$, $R_{21}$ and $R_{22}$ are hydrogen, and $R_{23}$ is $C_2$-$C_4$alkanoyl.

**8.** Use according to claim 7, wherein the component of the benzofuran-2-one type is a compound of formula Va or Vb

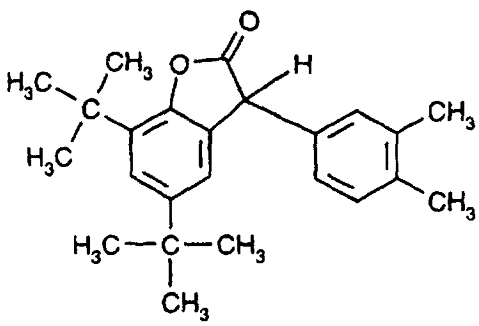

(Va)

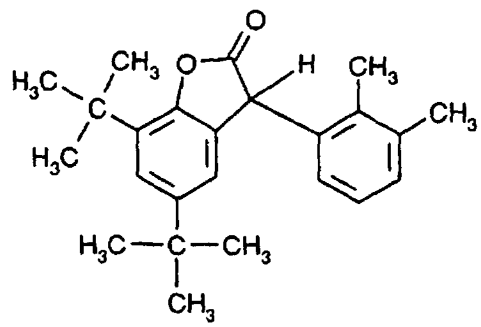

(Vb)

or a mixture of the two compounds of formulae Va and Vb.

**9.** Use according to claim 1, wherein the sterically hindered nitroxyl free-radical or the compound of the benzofuran-2-one type is present in an amount of from 0.0001 to 10% by weight, based on the total amount of monomer, oligomer, co-oligomer, polymer or copolymer.

**10.** A method of increasing the storage stability and preventing yellowing under the action of UV-light, of an UV-curable composition comprising

a1) at least one oligomer, co-oligomer, polymer or copolymer or a mixture thereof having at least one ethylenically unsaturated bond; or
a2) a mixture of at least one ethylenically unsaturated monomer with at least one oligomer, co-oligomer, polymer or copolymer having at least one ethylenically unsaturated bond, which method comprises adding at least one stable sterically hindered nitroxyl free-radical or at least one compound of the benzofuran-2-one type or a mixture of the two compounds.

**Patentansprüche**

**1.** Verwendung eines stabilen sterisch gehinderten freien Nitroxyl-Radikals oder einer Verbindung vom Typ der Benzofuran-2-one oder einer Mischung beider Verbindungen für die Erhöhung der Lagerstabilität einer UV-härtbaren Zusammensetzung und die Verhinderung der Vergilbung unter der Einwirkung von UV-Licht, wobei diese Zusammensetzung umfasst

a1) mindestens ein Oligomer, Cooligomer, Polymer oder Copolymer oder eine Mischung davon mit mindestens einer ethylenisch ungesättigten Bindung; oder
a2) eine Mischung aus mindestens einem ethylenisch ungesättigten Monomer mit mindestens einem Oligomer, Cooligomer, Polymer oder Copolymer mit mindestens einer ethylenisch ungesättigten Bindung.

**2.** Verwendung nach Anspruch 1, worin das Monomer, Oligomer, Cooligomer, Polymer oder Copolymer mindestens 2 ethylenisch ungesättigte Bindungen aufweist.

**3.** Verwendung nach Anspruch 1, worin das Monomer, Oligomer, Cooligomer, Polymer oder Copolymer mindestens eine Acrylat- oder Methacrylat-Funktionalität enthält oder ein von einer ungesättigten Säure abgeleiteter Polyester ist.

**4.** Verwendung nach Anspruch 1, worin die stabilen sterisch gehinderten freien Nitroxylradikale folgendes Strukturmerkmal aufweisen,

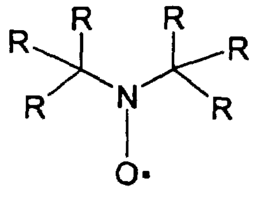

oder

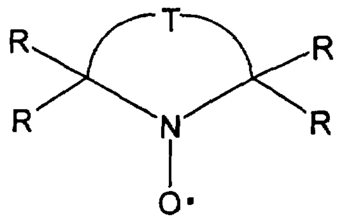

worin R für Alkyl steht und T eine Gruppe bedeutet, die zur Vervollständigung eines 5- oder 6-Ringes erforderlich ist.

**5.** Verwendung nach Anspruch 1, worin die stabilen sterisch gehinderten freien Nitroxylradikale ausgewählt werden aus der Gruppe bestehend aus
Bis(1-oxyl-2,2,6,6-tetramethylpiperidin-4-yl) sebacat, 4-Hydroxy-1-oxyl-2,2,6,6-tetramethylpiperidin, 4-Ethoxy-1-oxyl-2,2,6,6-tetramethylpiperidin, 4-Propoxy-1-oxyl-2,2,6,6-tetramethylpiperidin, 4-Acetamido-1-oxyl-2,2,6,6-tetramethylpiperidin, 1-Oxyl-2,2,6,6-tetramethylpiperidin, 1-Oxyl-2,2,6,6-tetramethylpiperidin-4-on, 1-Oxyl-2,2,6,6-tetramethylpiperidin-4-yl-acetat, 1-Oxyl-2,2,6,6-tetramethylpiperidin-4-yl-2-ethylhexanoat, 1-Oxyl-2,2,6,6-tetramethylpiperidin-4-yl-stearat, 1-Oxyl-2,2,6,6-tetramethylpiperidin-4-ylbenzoat, 1-Oxyl-2,2,6,6-tetramethylpiperidin-4-yl-4-t-butyl-benzoat, Bis(1-oxyl-2,2,6,6-tetramethylpiperidin-4-yl) succinat, Bis(1-oxyl-2,2,6,6-tetramethylpiperidin-4-yl) adipat, Bis(1-oxyl-2,2,6,6-tetramethylpiperidin-4-yl) n-butylmalonat, Bis(1-oxyl-2,2,6,6-tetramethylpiperidin-4-yl) phthalat, Bis(1-oxyl-2,2,6,6-tetramethylpiperidin-4-yl) isophthalat, Bis(1-oxyl-2,2,6,6-tetramethylpiperidin-4-yl) terephthalat, Bis(1-oxyl-2,2,6,6-tetramethylpiperidin-4-yl)-hexahydroterephthalat, N,N'-Bis(1-oxyl-2,2,6,6-tetramethylpiperidin-4-yl)adipamid, N-(1-Oxyl-2,2,6,6-tetramethylpiperidin-4-yl)caprolactam, N-(1-Oxyl-2,2,6,6-tetramethylpiperidin-4-yl)dodecylsuccinimid, 2,4,6-Tris-[N-butyl-N-(1-oxyl-2,2,6,6-tetramethylpiperidin-4-yl)]-striazin, 4,4'-Ethylen-bis(1-oxyl-2,2,6,6-tetramethylpiperazin-3-on), 2-Oxyl-1,1,3,3-tetramethyl-2-isobenzazol, 1-Oxyl-2,2,5,5-tetramethylpyrrolidin und N,N-Bis-(1,1,3,3-tetramethylbutyl)nitroxid.

**6.** Verwendung nach Anspruch 1, enthaltend als Komponente vom Typ der Benzofuran-2-one eine Verbindung der Formel I

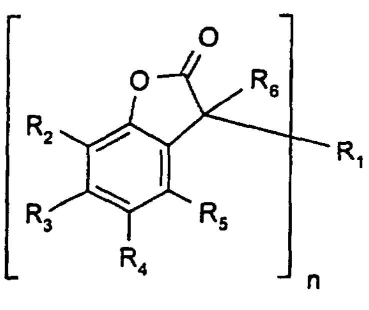

(I)

worin, wenn n 1 ist,

$R_1$ unsubstituiertes oder mit $C_1$-$C_4$-Alkyl, $C_1$-$C_4$-Alkoxy, $C_1$-$C_4$-Alkylthio, Hydroxy, Halogen, Amino, $C_1$-$C_4$-

Alkylamino, Phenylamino oder Di($C_1$-$C_4$-alkyl)amino substituiertes Naphthyl, Phenanthryl, Anthryl, 5,6,7,8-Tetrahydro-2-naphthyl, 5,6,7,8-Tetrahydro-1-naphthyl, Thienyl, Benzo[b]thienyl, Naphtho[2,3-b]thienyl, Thianthrenyl, Dibenzofuryl, Chromenyl, Xanthenyl, Phenoxathiinyl, Pyrrolyl, Imidazolyl, Pyrazolyl, Pyrazinyl, Pyrimidinyl, Pyridazinyl, Indolizinyl, Isoindolyl, Indolyl, Indazolyl, Purinyl, Chinolizinyl, Isochinolyl, Chinoiyl, Phthalazinyl, Naphthyridinyl, Chinoxalinyl, Chinazolinyl, Cinnolinyl, Pteridinyl, Carbazolyl, β-Carbolinyl, Phenanthridinyl, Acridinyl, Perimidinyl, Phenanthrolinyl, Phenazinyl, Isothiazolyl, Phenothiazinyl, Isoxazolyl, Furazanyl, Biphenyl, Terphenyl, Fluorenyl oder Phenoxazinyl darstellt, oder $R_1$ einen Rest der Formel II

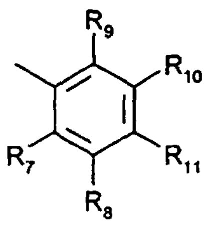

(II)

bedeutet, und

wenn n 2 ist,

$R_1$ unsubstituiertes oder mit $C_1$-$C_4$-Alkyl oder Hydroxy substituiertes Phenylen oder Naphthylen; oder -$R_{12}$-X-$R_{13}$- darstellt,

$R_2$, $R_3$, $R_4$ und $R_5$ unabhängig voneinander Wasserstoff, Chlor, Hydroxy, $C_1$-$C_{25}$-Alkyl, $C_7$-$C_9$-Phenylalkyl, unsubstituiertes oder durch $C_1$-$C_4$-Alkyl substituiertes Phenyl; unsubstituiertes oder durch $C_1$-$C_4$-Alkyl substituiertes $C_5$-$C_8$-Cycloalkyl; $C_1$-$C_{18}$-Alkoxy, $C_1$-$C_{18}$-Alkylthio, $C_1$-$C_4$-Alkylamino, Di-($C_1$-$C_4$-alkyl)amino, $C_1$-$C_{25}$-Alkanoyloxy, $C_1$-$C_{25}$-Alkanoylamino, $C_3$-$C_{25}$-Alkenoyloxy, durch Sauerstoff, Schwefel oder $>$N-$R_{14}$ unterbrochenes $C_3$-$C_{25}$-Alkanoyloxy; $C_6$-$C_9$-Cycloalkylcarbonyloxy, Benzoyloxy oder durch $C_1$-$C_{12}$-Alkyl substituiertes Benzoyloxy darstellen; oder femer die Reste $R_2$ und $R_3$ oder die Reste $R_3$ und $R_4$ oder die Reste $R_4$ und $R_5$ zusammen mit den Kohlenstoffatomen, an die sie gebunden sind, einen Benzoring bilden, oder $R_4$ zusätzlich -$(CH_2)_p$-$COR_{15}$ oder -$(CH_2)_q$OH darstellen kann, oder wenn $R_3$, $R_5$ und $R_6$ Wasserstoff sind, $R_4$ zusätzlich einen Rest der Formel III

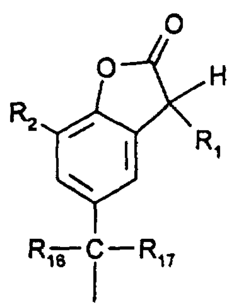

(III)

bedeuten kann, worin $R_1$ wie oben für n = 1 angegeben definiert ist,
$R_6$ Wasserstoff oder einen Rest der Formel IV

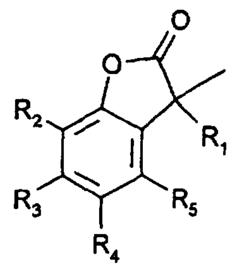

(IV)

darstellt, wobei $R_4$ nicht einen Rest der Formel III bedeutet und $R_1$ wie oben für n = 1 angegeben definiert ist, $R_7$, $R_8$, $R_9$, $R_{10}$ und $R_{11}$ unabhängig voneinander Wasserstoff, Halogen, Hydroxy, $C_1$-$C_{25}$-Alkyl, durch Sauerstoff, Schwefel oder $>N-R_{14}$ unterbrochenes $C_2$-$C_{25}$-Alkyl; $C_1$-$C_{25}$-Alkoxy, durch Sauerstoff, Schwefel oder $>N-R_{14}$ unterbrochenes $C_2$-$C_{25}$-Alkoxy; $C_1$-$C_{25}$-Alkylthio, $C_3$-$C_{25}$-Alkenyl, $C_3$-$C_{25}$-Alkenyloxy, $C_3$-$C_{25}$-Alkinyl, $C_3$-$C_{25}$-Alkinyloxy, $C_7$-$C_9$-Phenylalkyl, $C_7$-$C_9$-Phenylalkoxy, unsubstituiertes oder durch $C_1$-$C_4$-Alkyl substituiertes Phenyl; unsubstituiertes oder durch $C_1$-$C_4$-Alkyl substituiertes Phenoxy; unsubstituiertes oder durch $C_1$-$C_4$-Alkyl substituiertes $C_5$-$C_8$-Cycloalkyl; unsubstituiertes oder durch $C_1$-$C_4$-Alkyl substituiertes $C_5$-$C_8$-Cycloalkoxy; $C_1$-$C_4$-Alkylamino, Di-($C_1$-$C_4$-alkyl)amino, $C_1$-$C_{25}$-Alkanoyl, durch Sauerstoff, Schwefel oder $>N-R_{14}$ unterbrochenes $C_3$-$C_{25}$-Alkanoyl; $C_1$-$C_{25}$-Alkanoyloxy, durch Sauerstoff, Schwefel oder $>N-R_{14}$ unterbrochenes $C_3$-$C_{25}$-Alkanoyloxy; $C_1$-$C_{25}$-Alkanoylamino, $C_3$-$C_{25}$-Alkenoyl, durch Sauerstoff, Schwefel oder $>N-R_{14}$ unterbrochenes $C_3$-$C_{25}$-Alkenoyl; $C_3$-$C_{25}$-Alkenoyloxy, durch Sauerstoff, Schwefel oder $>N-R_{14}$ unterbrochenes $C_3$-$C_{25}$-Alkenoyloxy; $C_6$-$C_9$-Cycloalkylcarbonyl, $C_6$-$C_9$-Cycloalkylcarbonyloxy, Benzoyl oder durch $C_1$-$C_{12}$-Alkyl substituiertes Benzoyl; Benzoyloxy oder durch $C_1$-$C_{12}$-Alkyl substituiertes Benzoyloxy;

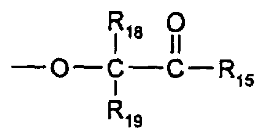

oder

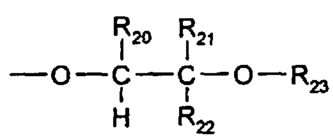

darstellen, oder femer in Formel II die Reste $R_7$ und $R_8$ oder die
Reste $R_8$ und $R_{11}$ zusammen mit den Kohlenstoffatomen, an die sie gebunden sind, einen Benzoring bilden,
$R_{12}$ und $R_{13}$ unabhängig voneinander unsubstituiertes oder durch $C_1$-$C_4$-Alkyl substituiertes Phenylen oder Naphthylen darstellen,
$R_{14}$ Wasserstoff oder $C_1$-$C_8$-Alkyl ist,
$R_{15}$ Hydroxy,

$$\left[-O^{-}\ \frac{1}{r}M^{r+}\right] ,$$

$C_1$-$C_{18}$-Alkoxy oder

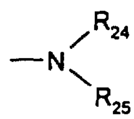

bedeutet,

$R_{16}$ und $R_{17}$ unabhängig voneinander Wasserstoff, $CF_3$, $C_1$-$C_{12}$-Alkyl oder Phenyl darstellen, oder $R_{16}$ und $R_{17}$ zusammen mit dem C-Atom, an das sie gebunden sind, einen unsubstituierten oder durch 1 bis 3 $C_1$-$C_4$-Alkyl substituierten $C_5$-$C_8$-Cycloalkylidenring bilden;

$R_{18}$ und $R_{19}$ unabhängig voneinander Wasserstoff, $C_1$-$C_4$-Alkyl oder Phenyl darstellen,

$R_{20}$ Wasserstoff oder $C_1$-$C_4$-Alkyl ist,

$R_{21}$ Wasserstoff, unsubstituiertes oder durch $C_1$-$C_4$-Alkyl substituiertes Phenyl; $C_1$-$C_{25}$-Alkyl, durch Sauerstoff, Schwefel oder $>N-R_{14}$ unterbrochenes $C_2$-$C_{25}$-Alkyl; unsubstituiertes oder am Phenylrest durch 1 bis 3 $C_1$-$C_4$-Alkyl substituiertes $C_7$-$C_9$-Phenylalkyl; durch Sauerstoff, Schwefel oder $>N-R_{14}$ unterbrochenes unsubstituiertes oder am Phenylrest durch 1 bis 3 $C_1$-$C_4$-Alkyl substituiertes $C_7$-$C_{25}$-Phenylalkyl bedeutet, oder femer die Reste $R_{20}$ und

$R_{21}$ zusammen mit den Kohlenstoffatomen, an die sie gebunden sind, einen unsubstituierten oder durch 1 bis 3 $C_1$-$C_4$-Alkyl substituierten $C_5$-$C_{12}$-Cycloalkylenring bilden;

$R_{22}$ Wasserstoff oder $C_1$-$C_4$-Alkyl darstellt,

$R_{23}$ Wasserstoff, $C_1$-$C_{25}$-Alkanoyl, $C_3$-$C_{25}$-Alkenoyl, durch Sauerstoff, Schwefel oder $>N-R_{14}$ unterbrochenes $C_3$-$C_{25}$-Alkanoyl; durch eine Di($C_1$-$C_6$-alkyl)phosphonatgruppe substituiertes $C_2$-$C_{25}$-Alkanoyl; $C_6$-$C_9$-Cycloalkylcarbonyl, Thenoyl, Furoyl, Benzoyl oder durch $C_1$-$C_{12}$-Alkyl substituiertes Benzoyl;

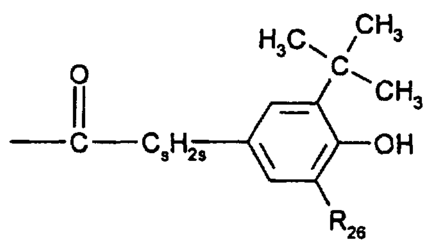
,

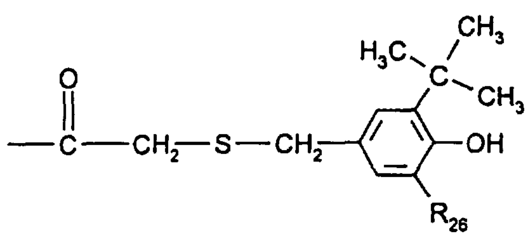
,
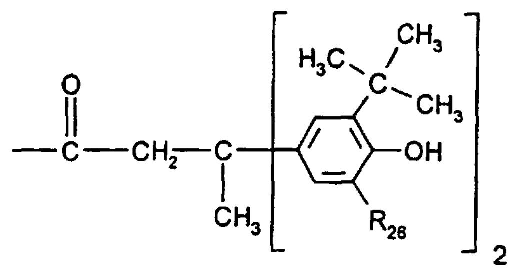
,

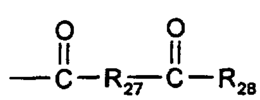
oder
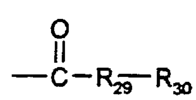

bedeutet,

$R_{24}$ und $R_{25}$ unabhängig voneinander Wasserstoff oder $C_1$-$C_{18}$-Alkyl darstellen,

$R_{26}$ Wasserstoff oder $C_1$-$C_8$-Alkyl darstellt,

$R_{27}$ eine direkte Bindung, $C_1$-$C_{18}$-Alkylen, durch Sauerstoff, Schwefel oder $>N-R_{14}$ unterbrochenes $C_2$-$C_{18}$-Alkylen; $C_2$-$C_{18}$-Alkenylen, $C_2$-$C_{20}$-Alkyliden, $C_7$-$C_{20}$-Phenylalkyliden, $C_5$-$C_8$-Cycloalkylen, $C_7$-$C_8$-Bicycloalkylen, unsubstituiertes oder durch $C_1$-$C_4$-Alkyl substituiertes Phenylen,

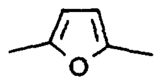 oder 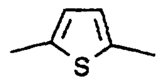

darstellt,
$R_{28}$ Hydroxy,

$$\left[-O^{-}\ \frac{1}{r}M^{r+}\right],$$

$C_1$-$C_{18}$-Alkoxy oder

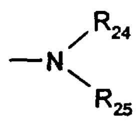

bedeutet,
$R_{29}$ Sauerstoff, -NH- oder

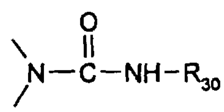

darstellt,
$R_{30}$ $C_1$-$C_{18}$-Alkyl oder Phenyl ist,
$R_{31}$ Wasserstoff oder $C_1$-$C_{18}$-Alkyl bedeutet,
M ein r-wertiges Metallkation ist,
X eine direkte Bindung, Sauerstoff, Schwefel oder -$NR_{31}$- darstellt,
n 1 oder 2 ist,
p 0, 1 oder 2 bedeutet,
q 1, 2, 3, 4, 5 oder 6 darstellt,
r 1, 2 oder 3 ist, und
s 0, 1 oder 2 bedeutet.

**7.** Verwendung gemäss Anspruch 6, enthaltend als Komponente vom Typ der Benzofuran-2-one eine Verbindung der Formel V

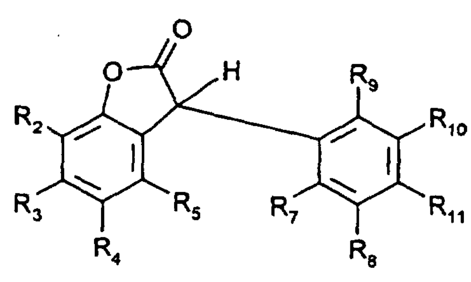 (V),

worin

$R_2$ Wasserstoff oder $C_1$-$C_6$-Alkyl darstellt,

$R_3$ Wasserstoff bedeutet,
$R_4$ Wasserstoff oder $C_1$-$C_6$-Alkyl darstellt,
$R_5$ Wasserstoff bedeutet,
$R_7$, $R_8$, $R_9$, $R_{10}$ und $R_{11}$ unabhängig voneinander Wasserstoff, $C_1$-$C_4$-Alkyl, $C_1$-$C_4$-Alkoxy oder

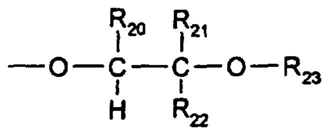

darstellen, mit der Bedingung, dass mindestens zwei der Reste
$R_7$, $R_8$, $R_9$, $R_{10}$ oder $R_{11}$ Wasserstoff sind,
$R_{20}$, $R_{21}$ und $R_{22}$ Wasserstoff bedeuten, und
$R_{23}$ $C_2$-$C_4$-Alkanoyl darstellt.

**8.** Verwendung gemäss Anspruch 7, worin die Komponente vom Typ der Benzofuran-2-one eine Verbindung der Formel Va oder Vb

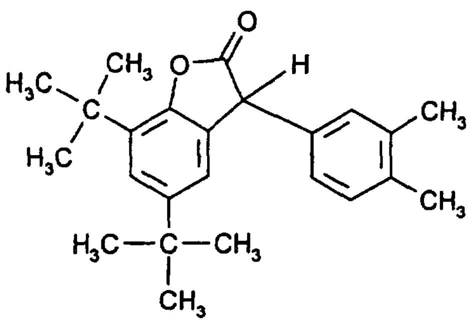

(Va)

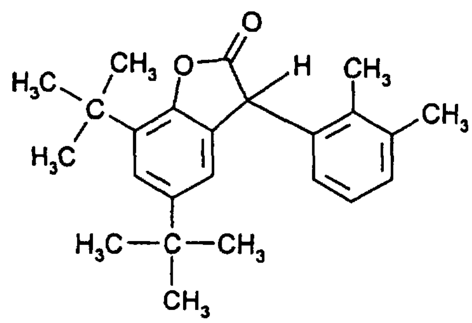

(Vb)

darstellt, oder ein Gemisch der beiden Verbindungen der Formel Va und Vb bedeutet.

**9.** Verwendung nach Anspruch 1, worin das sterisch gehinderte freie Nitroxyl-Radikal oder die Verbindung vom Typ der Benzofuran-2-one in einer Menge von 0,0001-10 Gew.-%, bezogen auf die Gesamtmenge an Monomer, Oligomer, Cooligomer, Polymer oder Copolymer enthalten ist.

**10.** Verfahren zur Erhöhung der Lagerstabilität und Verhinderung einer Vergilbung unter der Einwirkung von UV-Licht einer UV-härtbaren Zusammensetzung, umfassend

a1) mindestens ein Oligomer, Cooligomer, Polymer oder Copolymer oder eine Mischung davon mit mindestens einer ethylenisch ungesättigten Bindung; oder
a2) eine Mischung aus mindestens einem ethylenisch ungesättigten Monomer mit mindestens einem Oligomer, Cooligomer, Polymer oder Copolymer mit mindestens einer ethylenisch ungesättigten Bindung,

wobei das Verfahren die Zugabe von mindestens einem stabilen sterisch gehinderten freien Nitroxyl-Radikal oder mindestens einer Verbindung vom Typ der Benzofuran-2-one oder eine Mischung beider Verbindungen umfasst.

## Revendications

**1.** Utilisation d'un radical libre nitroxyle à encombrement stérique stable ou d'un composé du type benzofuran-2-one ou d'un mélange des deux composés pour augmenter la stabilité de conservation d'une composition durcissable

aux rayons ultraviolets et pour empêcher son jaunissement sous l'action de la lumière ultraviolette, ladite composition comprenant

a1) au moins un oligomère, co-oligomère, polymère ou copolymère ayant au moins une liaison insaturée éthylénique, ou un mélange de ceux-ci ; ou
a2) un mélange d'au moins un monomère à insaturation éthylénique avec au moins un oligomère, co-oligomère, polymère ou copolymère ayant au moins une liaison insaturée éthylénique.

**2.** Utilisation selon la revendication 1, dans laquelle le monomère, l'oligomère, le co-oligomère, le polymère ou le copolymère possède au moins 2 liaisons insaturées éthyléniques.

**3.** Utilisation selon la revendication 1, dans laquelle le monomère, l'oligomère, le co-oligomère, le polymère ou le copolymère contient au moins une fonctionnalité acrylate ou méthacrylate ou est un polyester dérivé d'un acide insaturé.

**4.** Utilisation selon la revendication 1, dans laquelle les radicaux libres nitroxyle à encombrement stérique stables présentent la particularité structurelle suivante,

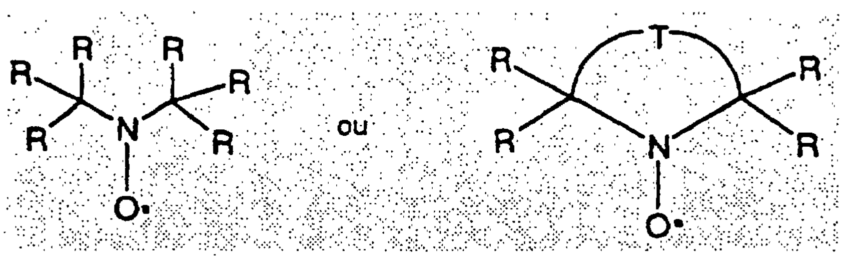

dans laquelle R représente un groupe alkyle et T représente un groupe nécessaire pour compléter un cycle à à 5 ou 6 éléments.

**5.** Utilisation selon la revendication 1, dans laquelle les radicaux libres nitroxyle à encombrement stérique stables sont choisis dans le groupe formé par

le sébacate de bis(1-oxy-2,2,6,6-tétraméthylpipéridin-4-yle), la 4-hydroxy-1-oxy-2,2,6,6-tétraméthyl-pipéridine, la 4-éthoxy-1-oxy-2,2,6,6-tétraméthylpipéridine, la 4-propoxy-1-oxy-2,2,6,6-tétra-méthylpipéridine, le 4-acétamido-1-oxy-2,2,6,6-tétraméthylpipéridine, la 1-oxy-2,2,6,6-tétra-méthylpipéridine, la 1-oxy-2,2,6,6-tétraméthylpipéridin-4-one, l'acétate de 1-oxy-2,2,6,6-tétraméthyl-pipéridin-4-yle, le 2-éthylhexanoate de 1-oxy-2,2,6,6-tétraméthylpipéridin-4-yle, le stéarate de 1-oxy-2,2,6,6-tétraméthylpipéridin-4-yle, le benzoate de 1-oxy-2,2,6,6-tétraméthylpipéridin-4-yle, le 4-tert-butyl-benzoate de 1-oxy-2,2,6,6-tétraméthylpipéridin-4-yle, le succinate de bis (1-oxy-2,2,6,6-tétraméthyl-pipéridin-4-yle), l'adipate de bis(1-oxy-2,2,6,6-tétraméthylpipéridin-4-yle), le n-butylmalonate de bis(1-oxy-2,2,6,6-tétraméthylpipéridin-4-yle), le phtalate de bis(1-oxy-2,2,6,6-tétraméthylpipéridin-4-yle), l'isophtalate de bis(1-oxy-2,2,6,6-tétraméthylpipéridin4-yle), le téréphtalate de bis(1-oxy-2,2,6,6-tétraméthylpipéridin-4-yle), l'hexahydrotéréphtalate de bis(1-oxy-2,2,6,6-tétraméthylpipéridin-4-yle), le N,N'-bis(1-oxy-2,2,6,6-tétraméthylpipéridin-4-yl)adipamide, la N-(1-oxy-2,2,6,6-tétraméthylpipéridin-4-yl)caprolactame, le N-(1-oxy-2,2,6,6-tétraméthylpipéridin-4-yl)-dodécylsuccinimide, la 2,4,6-tris[N-butyl-N-(1-oxy-2,2,6,6-tétraméthylpipéridin-4-yl)]-s-triazine, la 4,4'-éthylènebis(1-oxy-2,2,6,6-tétraméthylpipérazin-3-one), la 2-oxy-1,1,3,3-tétraméthyl-2-isobenzazole, la 1-oxy-2,2,5,5-tétraméthylpyrrolidine et le N,N-bis(1,1,3,3-tétraméthylbutyl)-nitroxyde.

**6.** Utilisation selon la revendication 1, comprenant, en tant que composant du type benzofuran-2-one un composé de formule I

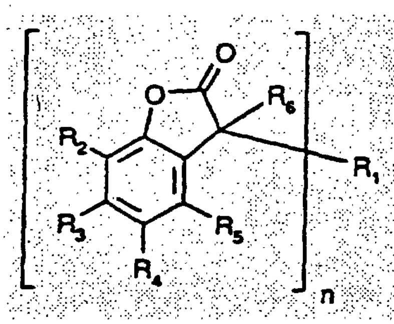

(I),

dans laquelle, lorsque n vaut 1,

$R_1$ représente un groupe naphtyle, phénanthryle, anthryle, 5,6,7,8-tétrahydro-2-naphtyle, 5,6,7,8-tétrahydro-1-naphtyle, thiényle, benzo[b]thiényle, naphto[2,3-b]thiényle, thianthrényle, dibenzofuryle, chroményle, xanthényle, phénoxathiinyle, pyrrolyle, imidazolyle, pyrazolyle, pyrazinyle, pyrimidinyle, pyridazinyle, indolizinyle, isoindolyle, indolyle, indazolyle, purinyle, quinolizinyle, isoquinoléyle, quinoléyle, phtalazinyle, naphtyridinyle, quinoxalinyle, quinazolinyle, cinnolinyle, ptéridinyle, carbazolyle, β-carbolinyle, phénanthridinyle, acridinyle, périmidinyle, phénanthrolinyle, phénazinyle, isothiazolyle, phénothiazinyle, isoxazolyle, furazanyle, biphényle, terphényle, fluorényle ou phénoxazinyle, chacun non substitué ou substitué par un groupe alkyle en $C_1$ à $C_4$, alcoxy en $C_1$ à $C_4$, alkylthio en $C_1$ à $C_4$, hydroxy, halogéno, amino, alkylamino en $C_1$ à $C_4$, phénylamino ou di(alkyle en $C_1$ à $C_4$)amino, ou $R_1$ représente un groupe de formule II

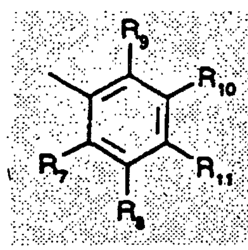

(II), et

lorsque n vaut 2,

$R_1$ représente un groupe phénylène ou naphtylène, chacun non substitué ou substitué par un groupe alkyle en $C_1$ à $C_4$ ou par un groupe hydroxyle ; ou représente $-R_{12}-X-R_{13}-$,
$R_2$, $R_3$, $R_4$ et $R_5$ représentent, chacun indépendamment les uns des autres, un atome d'hydrogène, un atome de chlore, un groupe hydroxy, alkyle en $C_1$ à $C_{25}$, phénylalkyle en $C_7$ à $C_9$, phényle non substitué ou substitué par un groupe alkyle en $C_1$ à $C_4$ ; cycloalkyle en $C_5$ à $C_8$ non substitué ou substitué par un groupe alkyle en $C_1$ à $C_4$ ; alcoxy en $C_1$ à $C_{18}$, alkylthio en $C_1$ à $C_{18}$, alkylamino en $C_1$ à $C_4$, di(alkyle en $C_1$ à $C_4$)amino, alcanoyloxyen $C_1$ à $C_{25}$, alcanoylamino en $C_1$ à $C_{25}$, alcénoyloxy en $C_3$ à $C_{25}$, alcanoyloxy en $C_3$ à $C_{25}$ interrompu par un atome d'oxygène, de soufre ou par

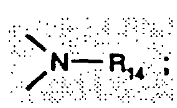 ;

(cycloalkyle en $C_6$ à $C_9$)carbonyloxy, benzoyloxy ou benzoyloxy substitué par un groupe alkyle en $C_1$ à $C_{12}$ ; ou les groupes $R_2$ et $R_3$ ou les groupes $R_3$ et $R_4$ ou les groupes $R_4$ et $R_5$, conjointement avec les atomes de carbone auxquels ils sont liés, forment un cycle benzo, ou $R_4$ peut en outre représenter un groupe $-(CH_2)_p-COR_{15}$ ou $-(CH_2)_qOH$, ou, lorsque $R_3$, $R_5$ et $R_6$ représentent des atomes d'hydrogène, $R_4$ peut en outre représenter un radical de formule III

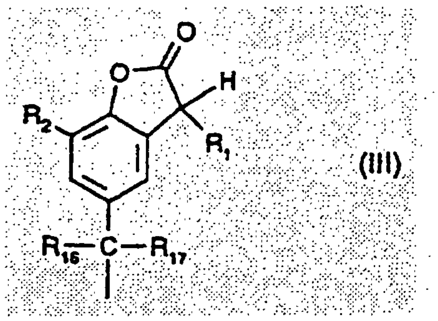

dans laquelle $R_1$ est tel que défini ci-dessus pour n = 1, $R_6$ représente un atome d'hydrogène ou un groupe de formule IV

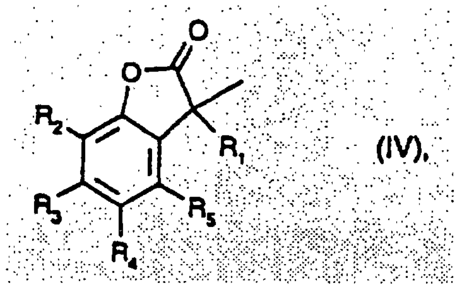

dans laquelle $R_4$ n'est pas un groupe de formule III et $R_1$ est tel que défini ci-dessus pour n= 1,

$R_7$, $R_8$, $R_9$, $R_{10}$ et $R_{11}$ représentent chacun, indépendamment les uns des autres, un atome d'hydrogène, un atome d'halogène, un groupe hydroxyle, alkyle en $C_1$ à $C_{25}$, alkyle en $C_2$ à $C_{25}$ interrompu par un atome d'oxygène, de soufre ou par

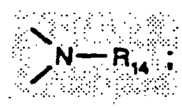

$>$N-$R_{14}$ ; alcoxy en $C_1$ à $C_{25}$, alcoxy en $C_2$ à $C_{25}$ interrompu par un atome d'oxygène, de soufre ou par

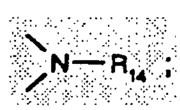

$>$N-$R_{14}$ ; alkylthio en $C_1$ à $C_{25}$, alcényle en $C_3$ à $C_{25}$, alcényloxy en $C_3$ à $C_{25}$, alcynyle en $C_3$ à $C_{25}$, alcynyloxy en $C_3$ à $C_{25}$, phénylalkyle en $C_7$ à $C_9$, phénylalcoxy en $C_7$ à $C_9$, phényle non substitué ou substitué par un groupe alkyle en $C_1$ à $C_4$ ; phénoxy non substitué ou substitué par un groupe alkyle en $C_1$ à $C_4$ ; cycloalkyle en $C_5$ à $C_8$ non substitué ou substitué par un groupe alkyle en $C_1$ à $C_4$ ; cycloalcoxy en $C_5$ à $C_8$ non substitué ou substitué par un groupe alkyle en $C_1$ à $C_4$ ; alkylamino en $C_1$ à $C_4$, di(alkyle en $C_1$ à $C_4$)amino, alcanoyle en $C_1$ à $C_{25}$, alcanoyle en $C_3$ à $C_{25}$ interrompu par un atome d'oxygène, de soufre ou par

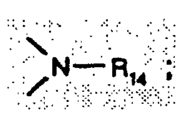

alcanoyloxy en $C_1$ à $C_{25}$, alcanoyloxy en $C_3$ à $C_{25}$ interrompu par un atome d'oxygène, de soufre ou par

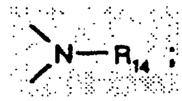

alcanoylamino en $C_1$ à $C_{25}$, alcénoyle en $C_3$ à $C_{25}$, alcénoyle en $C_3$ à $C_{25}$ interrompu par un atome d'oxygène, de soufre ou par

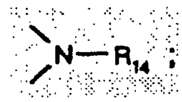

alcénoyloxy en $C_3$ à $C_{25}$, alcénoyloxy en $C_3$ à $C_{25}$ interrompu par un atome d'oxygène, de soufre ou par

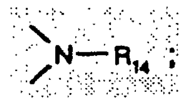

(cycloalkyle en $C_6$ à $C_9$)carbonyle, (cycloalkyle en $C_6$ à $C_9$)carbonyloxy, benzoyle ou benzoyle substitué par un groupe alkyle en $C_1$ à $C_{12}$ ; benzoyloxy ou benzoyloxy substitué par un groupe alkyle en $C_1$ à

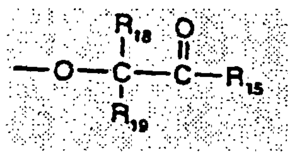 ou 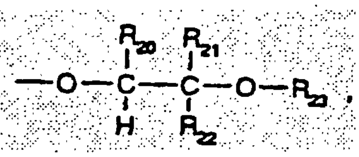

ou dans la formule II, les groupes $R_7$ et $R_8$ ou les groupes $R_8$ et $R_{11}$, conjointement avec les atomes de carbone auxquels ils sont liés, forment un cycle benzo, $R_{12}$ et $R_{13}$ représentent chacun, indépendamment l'un de l'autre, un groupe phénylène ou naphtylène non substitué ou substitué par un groupe alkyle en $C_1$ à $C_4$,
$R_{14}$ représente un atome d'hydrogène ou un groupe alkyle en $C_1$ à $C_8$,
$R_{15}$ représente un groupe hydroxyle,

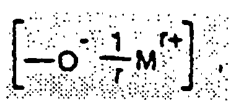

alcoxy en $C_1$ à $C_{18}$ ou

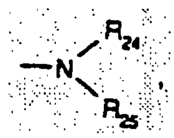

$R_{16}$ et $R_{17}$ représentent chacun, indépendamment l'un de l'autre, un atome d'hydrogène, $CF_3$, un groupe alkyle en $C_1$ à $C_{12}$ ou phényle, ou $R_{16}$ et $R_{17}$, conjointement avec les atomes de carbone auxquels ils sont liés, forment un cycle cycloalkylidène en $C_5$ à $C_8$ qui est non substitué ou substitué par 1 à 3 groupes alkyle en $C_1$ à $C_4$ ;
$R_{18}$ et $R_{19}$ représentent chacun, indépendamment l'un de l'autre, un atome d'hydrogène, un groupe alkyle en $C_1$ à $C_4$ ou phényle,

$R_{20}$ représente un atome d'hydrogène ou un groupe alkyle en $C_1$ à $C_4$,
$R_{21}$ représente un atome d'hydrogène, un groupe phényle non substitué ou substitué par un groupe alkyle en $C_1$ à $C_4$ ; alkyle en $C_1$ à $C_{25}$, alkyle en $C_2$ à $C_{25}$ interrompu par un atome d'oxygène, de soufre ou par

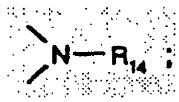

phénylalkyle en $C_7$ à $C_9$ qui est non substitué ou substitué sur le groupe phényle par 1 à 3 groupes alkyle en $C_1$ à $C_4$ ; phénylalkyle en $C_7$ à $C_{25}$ qui est non substitué ou substitué sur le groupe phényle par 1 à 3 groupes alkyle en $C_1$ à $C_4$ et interrompu par un atome d'oxygène, de soufre ou par

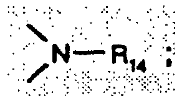

ou les groupes $R_{20}$ et $R_{21}$, conjointement avec les atomes de carbone auxquels ils sont liés, forment un cycle cycloalkylène en $C_5$ à $C_{12}$ qui est non substitué ou substitué par 1 à 3 groupes alkyle en $C_1$ à $C_4$ ;
$R_{22}$ représente un atome d'hydrogène ou un groupe alkyle en $C_1$ à $C_4$,
$R_{23}$ représente un atome d'hydrogène, un groupe alcanoyle en $C_1$ à $C_{25}$, alcénoyle en $C_3$ à $C_{25}$, alcanoyle en $C_3$ à $C_{25}$ interrompu par un atome d'oxygène, de soufre ou par

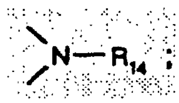

alcanoyle en $C_2$ à $C_{25}$ substitué par un groupe di(alkyle en $C_1$ à $C_6$)phosphonate ; (cycloalkyle en $C_6$ à $C_9$) carbonyle, thénoyle, furoyle, benzoyle ou benzoyle substitué par un groupe alkyle en $C_1$ à $C_{12}$ ;

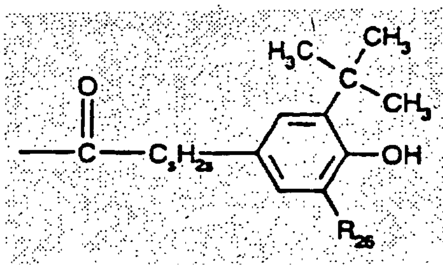 , 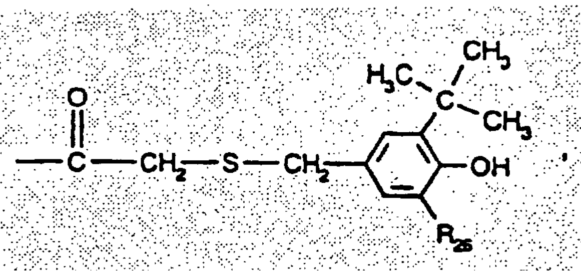 ,

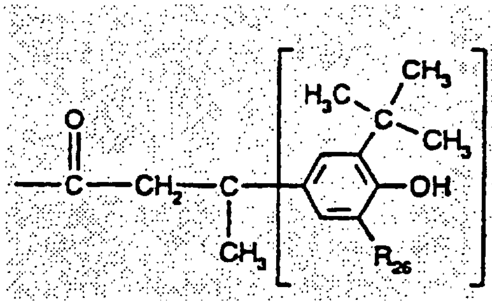 , 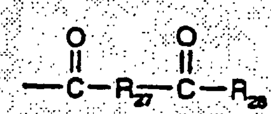 ou 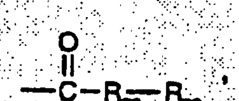 ,

$R_{24}$ et $R_{25}$ représentent chacun, indépendamment l'un de l'autre, un atome d'hydrogène ou un groupe alkyle en $C_1$ à $C_{18}$,
$R_{26}$ représente un atome d'hydrogène ou un groupe alkyle en $C_1$ à $C_8$,
$R_{27}$ représente une liaison directe, un groupe alkylène en $C_1$ à $C_{18}$, alkylène en $C_2$ à $C_{18}$ interrompu par un atome d'oxygène, de soufre ou par

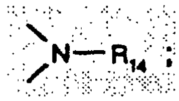

alcénylène en $C_2$ à $C_{18}$, alkylidène en $C_2$ à $C_{20}$, phénylalkylidène en $C_7$ à $C_{20}$, cycloalkylène en $C_5$ à $C_8$, bicycloalkylène en $C_7$ à $C_8$, phénylène non substitué ou substitué par un groupe alkyle en $C_1$ à $C_4$,

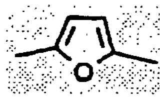 ou 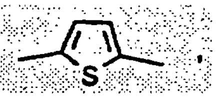 ,

$R_{28}$ représente un groupe hydroxyle,

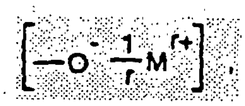

alcoxy en $C_1$ à $C_{18}$ ou

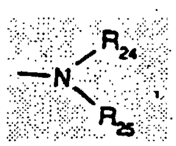

$R_{29}$ représente un atome d'oxygène, -NH- ou

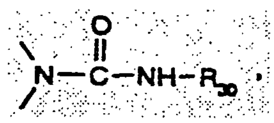

$R_{30}$ représente un groupe alkyle en $C_1$ à $C_{18}$ ou phényle,
$R_{31}$ représente un atome d'hydrogène ou un groupe alkyle en $C_1$ à $C_{18}$,
M représente un cation métallique de valence r,
X représente une liaison directe, un atome d'oxygène, de soufre ou $-NR_{31}-$,
n vaut 1 ou 2,
p vaut 0, 1 ou 2,
q vaut 1, 2, 3, 4, 5 ou 6,
r vaut 1, 2 ou 3, et
s vaut 0, 1 ou 2.

**7.** Utilisation selon la revendication 6, comprenant, en tant que composant du type benzofuran-2-one un composé de formule V

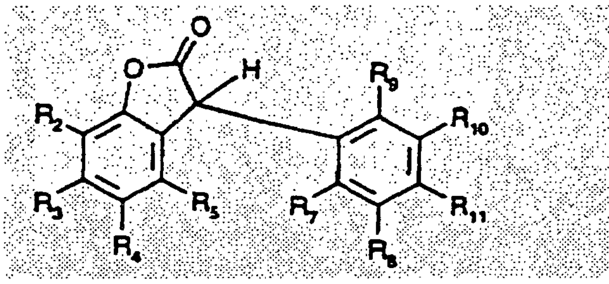 (V)

dans laquelle

$R_2$ représente un atome d'hydrogène ou un groupe alkyle en $C_1$ à $C_6$,
$R_3$ représente un atome d'hydrogène,
$R_4$ représente un atome d'hydrogène ou un groupe alkyle en $C_1$ à $C_6$,
$R_5$ représente un atome d'hydrogène,
$R_7$, $R_8$, $R_9$, $R_{10}$ et $R_{11}$ représentent chacun, indépendamment les uns des autres, un atome d'hydrogène, un groupe alkyle en $C_1$ à $C_4$, alcoxy en $C_1$ à $C_4$ ou

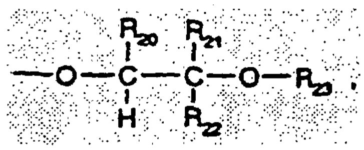

à condition qu'au moins deux des groupes $R_7$, $R_8$, $R_9$, $R_{10}$ et $R_{11}$ représentent des atomes d'hydrogène, $R_{20}$, $R_{21}$ et $R_{22}$ représentent des atomes d'hydrogène, $R_{23}$ représente un groupe alcanoyle en $C_2$ à $C_4$.

**8.** Utilisation selon la revendication 7, dans laquelle le composant du type benzofuran-2-one est un composé de formule Va ou Vb

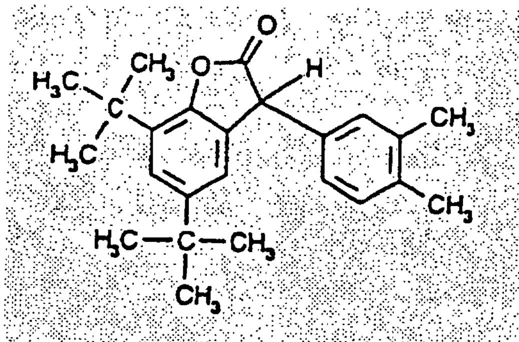

(Va)

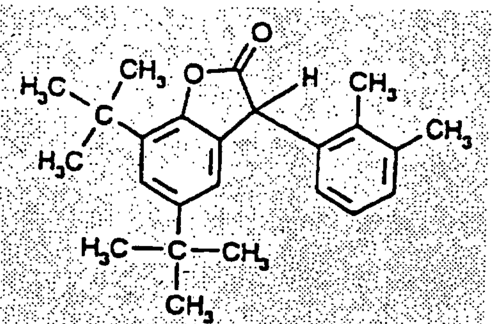

(Vb)

ou un mélange des deux composés de formules Va et Vb.

**9.** Utilisation selon la revendication 1, dans laquelle le radical libre nitroxyle à encombrement stérique ou le composé du type benzofuran-2-one est présent en une quantité de 0,0001% à 10% en poids, sur la base de la quantité totale de monomère, d'oligomère, de co-oligomère, de polymère ou de copolymère.

**10.** Procédé pour augmenter la stabilité de conservation et empêcher le jaunissement sous l'action de la lumière ultraviolette d'une composition durcissable aux UV comprenant

a1) au moins un oligomère, co-oligomère, polymère ou copolymère ayant au moins une liaison insaturée éthylénique, ou un mélange de ceux-ci ; ou
a2) un mélange d'au moins un monomère à insaturation éthylénique avec au moins un oligomère, co-oligomère, polymère ou copolymère ayant au moins une liaison insaturée éthylénique, lequel procédé comprenant un ajout d'au moins un radical libre nitroxyle à encombrement stérique stable ou d'au moins un composé du type benzofuran-2-one ou un mélange des deux composés.